# FASCICULE DE BREVET EUROPEEN

(11) **EP 2 909 869 B1**
(45) Date de publication et mention de la délivrance du brevet: **21.03.2018**
(21) Numéro de dépôt: 13777270.3
(22) Date de dépôt: 15.10.2013
(51) Int. Cl.: H01L 41/00, H02N 2/18, H01L 41/113

(54) **GENERATEUR D'ELECTRICITE**
STROMGENERATOR
ELECTRICITY GENERATOR

(30) Priorité: 22.10.2012 FR 1260047
(43) Date de publication de la demande: 26.08.2015
(73) Titulaire: Commissariat à l'Energie Atomique et aux Energies Alternatives, 75015 Paris (FR); Institut Polytechnique de Grenoble, 38500 Grenoble (FR); Centre National de la Recherche Scientifique, 75016 Paris (FR)
(72) Inventeur: VIALA, Bernard, F-38360 Sassenage (FR); LEBEDEV, Gor, F-38100 Grenoble (FR); DELAMARE, Jérome, F-38000 Grenoble (FR); GARBUIO, Lauric, F-38410 Pinet D'uriage (FR); LAFONT, Thomas, F-30460 Lasalle (FR); CUGAT, Orphée, F-38320 Poisat (FR)
(74) Mandataire: GIE Innovation Competence Group
(86) Numéro de dépôt international: PCT/EP2013/071479
(87) Numéro de publication internationale: WO 2014/063951

(56) Documents cités:
- EP-A1- 1 426 995
- US-A1- 2012 133 151
- US-B1- 6 522 048
- THOMAS LAFONT ET AL: "Paper;Magnetostrictive piezoelectric composite structures for energy harvesting;Magnetostrictive--piezoelectric composite structures for energy harvesting", JOURNAL OF MICROMECHANICS & MICROENGINEERING, INSTITUTE OF PHYSICS PUBLISHING, BRISTOL, GB, vol. 22, no. 9, 24 août 2012 (2012-08-24), page 94009, XP020228735, ISSN: 0960-1317, DOI: 10.1088/0960-1317/22/9/094009 cité dans la demande

## Description

L'invention concerne un générateur d'électricité.

Des systèmes auto-alimentés comme, par exemple, des réseaux de capteurs autonomes sans fil nécessitent un générateur d'électricité in situ. Ces systèmes sont souvent complexes et comprennent de nombreux éléments qui sont parfois installés hors de portée. Dans ces situations, la maintenance du système est compliquée et coûteuse si, par exemple, un remplacement de batterie déchargée devenait nécessaire. Il est donc souhaitable de ne pas remplacer la batterie pendant toute la durée de vie du système afin de réduire les coûts de maintenance et d'éliminer les déchets associés.

C'est dans ce contexte que des générateurs d'électricité équipés de récupérateur d'énergie ont été proposés. La récupération d'énergie est basée sur l'utilisation de sources d'énergie disponibles gratuitement dans l'environnement telles que la lumière, les changements de température, les vibrations ou autres, pour générer de l'électricité. Pour cette conversion, on utilise un convertisseur d'énergie.

En sortie du convertisseur d'énergie, il est souhaitable de récupérer l'énergie sous une tension utile élevée pour être facilement mise en forme par une charge alimentée par ce générateur électrique sans trop de déperdition d'énergie.

Ainsi, il a été proposé, dans la demande WO 2007/063194, d'utiliser un circuit de collecte et un dispositif de commande de ce circuit de collecte qui permettent de transférer l'énergie générée par le convertisseur vers la charge à alimenter uniquement lorsque cette énergie a atteint un seuil suffisant.

Ainsi, des générateurs connus d'électricité comportent :
- un premier convertisseur équipé de première et seconde bornes de raccordement, ce premier convertisseur étant apte à convertir une variation d'une énergie à récupérer en un excédent correspondant de charges électriques sur la première borne de raccordement par rapport à la seconde borne,
- un circuit de collecte de l'excédent de charges électriques sur la première borne de raccordement, ce circuit étant équipé :
   - d'une borne de sortie par l'intermédiaire de laquelle sont délivrées les charges collectées, et
   - d'un premier interrupteur mécanique commandable raccordé à la première borne de raccordement, ce premier interrupteur étant apte à commuter entre une position ouverte dans laquelle il empêche la décharge des charges électriques à travers la première borne de raccordement et une position fermée dans laquelle il autorise la décharge des charges électriques à travers la première borne de raccordement, la position fermée dans l'interrupteur mécanique étant obtenue par la mise en appui d'un contact électrique directement sur un autre contact électrique de manière à établir une continuité électrique et la position ouverte étant obtenue par la séparation mécanique de ces deux contacts électriques et l'interposition entre ces deux contacts électriques d'un milieu électriquement isolant, et
- un dispositif de commande du premier interrupteur propre à commander la commutation de cet interrupteur vers sa position fermée quand l'excédent de charges électriques présent sur la première borne de raccordement dépasse un premier seuil prédéterminé.

Comme décrit dans la demande WO 2007/063194, les interrupteurs statiques du circuit de collecte sont typiquement des transistors ou des thyristors. Il est connu d'alimenter ces interrupteurs à partir des charges électriques produites par le premier convertisseur de manière à permettre un fonctionnement autonome du récupérateur d'énergie, c'est-à-dire en utilisant seulement l'énergie à récupérer.

De l'état de la technique est également connu de US 6 522 048 B1, EP 1 426 995 A1 et de l'article de Dimitry Zakharov et al : « Thermal energy conversion by coupled shape memory and piezoelectric effects», Journal of Micromechanics & Microengineering, volume 22, n°9, 24/08/2012, 99005.

L'invention vise à améliorer le rendement d'un tel générateur d'énergie. Le rendement est ici défini comme étant le rapport entre la quantité d'énergie réellement transmise à la charge à alimenter sur la quantité d'énergie produite par le premier convertisseur.

Elle a donc pour objet un générateur d'énergie conforme à la revendication 1.

Le déposant a découvert que lorsque la quantité d'énergie récupérable est faible et que le temps mis pour la récupérer est long, la baisse du rendement était en partie due à l'utilisation d'interrupteurs statiques dans le circuit de collecte.En effet, les transistors et thyristors ou similaires consomment de l'électricité lorsqu'ils commutent entre leur position fermée et ouverte. L'électricité consommée par les interrupteurs du circuit de collecte n'est donc pas transmise à la charge à alimenter par le générateur d'électricité. De plus, même dans la position ouverte, il existe toujours un courant de fuite dans les transistors et thyristors. Ce courant de fuite permet au premier convertisseur de se décharger en dehors des instants de commutation prévus. Ce problème de décharge du premier convertisseur par des courants de fuite est d'autant plus important que les variations de l'énergie à récupérer sont lentes et donc que la fréquence de commutation des interrupteurs est faible. Ainsi, la présence de transistors ou thyristors dans les récupérateurs d'énergie connus diminue leur rendement.

Dans le générateur ci-dessus, l'interrupteur commandable est un interrupteur mécanique et non pas un interrupteur statique tel qu'un transistor ou un thyristor comme dans les circuits de collecte connus. Dès lors, la commutation de cet interrupteur entre les positions ouverte et fermée ne consomme pas l'énergie électrique produite par le premier convertisseur. De plus, avec l'interrupteur mécanique il n'existe pas de courant de fuite. Le circuit de collecte peut donc être utilisé pour récupérer des charges sous une tension utile élevée même si les variations de l'énergie à récupérer sont très lentes.

Enfin, le fait que l'interrupteur mécanique utilisé soit un interrupteur magnétique permet de limiter la quantité d'énergie électrique consommée par cet interrupteur et son circuit de commande ce qui augmente l'autonomie du générateur.

Les modes de réalisation de ce générateur peuvent comporter une ou plusieurs des caractéristiques des revendications dépendantes.

Ces modes de réalisation du générateur présentent en outre les avantages suivants :
- utiliser le champ magnétique variable directement généré par la source d'énergie à récupérer pour commander le premier interrupteur permet de réaliser un dispositif de commande autonome qui ne consomme pas les charges électriques produites par le premier convertisseur et donc d'accroître encore plus le rendement du générateur électrique ;
- disposer différemment des interrupteurs magnétiques dans le champ magnétique d'une source de champ magnétique variable permet de commander la fermeture de ces interrupteurs à des moments différents synchronisés sur la quantité de charges électriques produites sans consommer les charges électriques produites ;
- utiliser un premier convertisseur comportant un premier transducteur électromécanique et un second transducteur magnétique permet de générer de l'électricité même à partir de variation très lente du champ magnétique et de limiter l'encombrement du premier convertisseur.
- utiliser un second convertisseur pour convertir une variation de l'énergie à récupérer en un champ magnétique variable permet de produire de l'électricité à partir d'une source d'énergie à récupérer autre qu'un champ magnétique variable;
- disposer différemment des interrupteurs magnétiques dans un champ magnétique variable permet de commander la fermeture de ces interrupteurs à des moments différents synchronisés sur l'excédent de charges électriques produit sans consommer les charges électriques produites ;
- utiliser un premier convertisseur comportant un premier transducteur électromécanique et un second transducteur apte à exercer une contrainte sur ce premier transducteur permet de générer de l'électricité même à partir de variation très lente de l'énergie à récupérer et de limiter l'encombrement du premier convertisseur ;
- utiliser en tant que second transducteur du premier convertisseur un transducteur thermomécanique permet de récupérer de l'énergie électrique à partir d'une variation de température et d'éviter d'avoir recours à des radiateurs pour imposer un gradient de température ;
- utiliser un matériau à mémoire de forme permet d'exercer des contraintes plus importantes sur le transducteur électromécanique ;
- utiliser le même transducteur thermomécanique pour le premier convertisseur et pour le dispositif de commande permet de limiter l'encombrement du récupérateur d'énergie.
- l'utilisation d'un premier et d'un second interrupteurs magnétiques raccordés entre la borne de sortie et, respectivement, les première et seconde bornes de raccordement permet de redresser la différence de potentiels entre les première et seconde bornes de raccordement du premier convertisseur en limitant le nombre de diodes utilisées et donc en limitant la consommation du circuit de collecte ;
- l'utilisation de premier et second interrupteurs magnétiques pour transférer l'excédent de charge du convertisseur d'une borne de raccordement vers l'autre en alternance, permet d'amplifier l'excédent de charges sur la borne de raccordement du convertisseur et donc de transférer en une seule fois une quantité de charges électriques plus importante à la charge à alimenter ;
- utiliser une bobine traversée par le courant généré par le premier convertisseur ainsi qu'un interrupteur magnétique placé dans le champ magnétique de cette bobine permet de commander la fermeture de cet interrupteur magnétique en réponse au franchissement par le courant électrique généré d'un troisième seuil prédéterminé en consommant très peu des charges produites par le premier convertisseur ;
- utiliser en tant que premier transducteur du premier convertisseur un matériau piézoélectrique permet de transformer simplement une variation de contrainte en électricité.

L'invention sera mieux comprise à la lecture de la description qui va suivre, donnée uniquement à titre d'exemple non limitatif et faite en se référant aux dessins sur lesquels :
- la figure 1 est un schéma général d'un générateur d'électricité ;
- la figure 2 est une illustration schématique d'un premier mode de réalisation du générateur d'électricité de la figure 1 ;
- la figure 3 est une illustration schématique d'un convertisseur d'énergie utilisé dans le générateur d'électricité de la figure 2 ;
- la figure 4 est une illustration schématique d'un interrupteur magnétique utilisé dans le générateur de la figure 2 ;
- la figure 5 est un organigramme d'un procédé de génération d'électricité à l'aide du générateur de la figure 2 ;
- les figures 6 et 7 sont des illustrations schématiques de deux positions de fonctionnement différentes du générateur d'électricité de la figure 2;
- la figure 8 est une illustration schématique d'un deuxième mode de réalisation du générateur d'électricité de la figure 1 ;
- la figure 9 est une illustration schématique d'un interrupteur magnétique utilisé dans le générateur d'électricité de la figure 8 ;
- la figure 10 est un organigramme d'un procédé de génération d'électricité à l'aide du générateur d'électricité de la figure 8 ;
- les figures 11 à 13 illustrent schématiquement trois positions de fonctionnement différentes du générateur d'électricité de la figure 8 ;
- les figures 14 et 15 sont des illustrations schématiques respectives de deux autres modes de réalisation d'un circuit de collecte susceptible d'être utilisé dans le générateur d'électricité de la figure 2 ou 8 ;
- la figure 16 est une illustration schématique d'un troisième mode de réalisation du générateur d'électricité de la figure 1 ;
- la figure 17 est une illustration schématique d'un convertisseur d'énergie utilisé dans le générateur d'électricité de la figure 16.

Dans ces figures, les mêmes références sont utilisées pour désigner les mêmes éléments.

Dans la suite de cette description, les caractéristiques et fonctions bien connues de l'homme du métier ne sont pas décrites en détail.

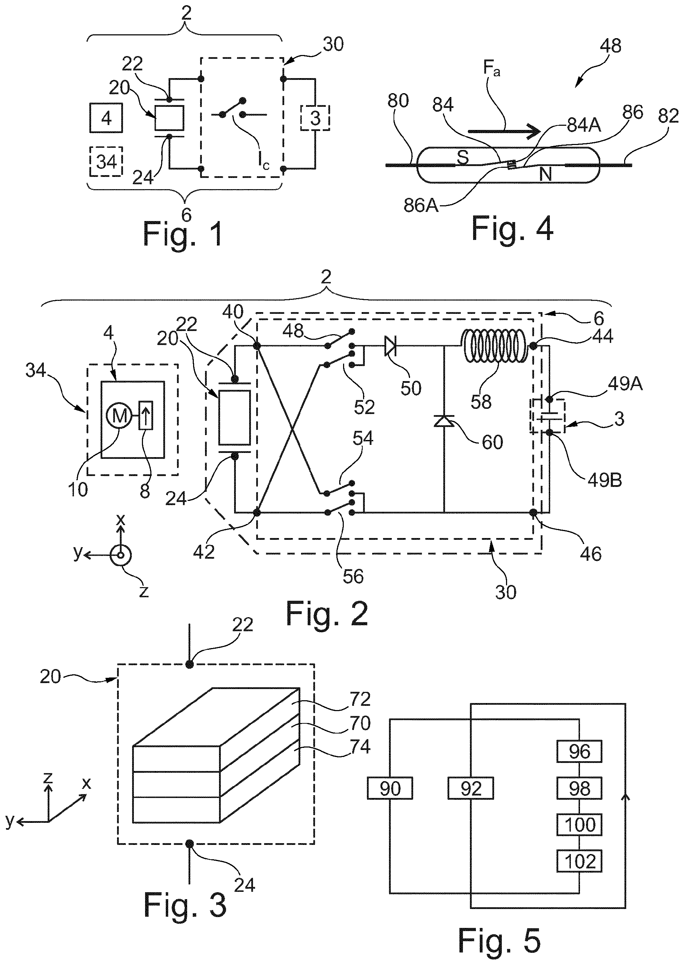

La figure 1 représente un générateur 2 d'électricité pour alimenter une charge électrique. Dans ce cas particulier, la charge électrique est une charge capable de stocker de l'énergie électrique. Par exemple, il s'agit d'un condensateur 3.

Le générateur 2 comporte une source 4 d'énergie à récupérer et un récupérateur 6 de cette énergie. Le récupérateur 6 alimente le condensateur 3 à partir de l'énergie récupérée.

La source 4 est une source d'énergie disponible gratuitement dans l'environnement du récupérateur 6.

Le récupérateur 6 comporte un convertisseur 20, un circuit 30 de collecte et un dispositif 34 de commande du circuit 30.

Le convertisseur 20 convertit une variation de l'énergie à récupérer en un excédent correspondant de charges électriques sur une borne 22 ou 24 de raccordement par rapport à l'autre borne 22 ou 24 de raccordement.

Le circuit 30 collecte l'excédent de charges électriques sur la borne 22 ou 24 et transfert les charges électriques collectées au condensateur 3. Pour cela il est équipé d'un ou plusieurs interrupteurs mécaniques commandables Ic.

Le dispositif 34 commande les interrupteurs Ic de manière à transférer l'excédent de charges électriques généré par le convertisseur 20 vers le condensateur 3 uniquement lorsque cet excédent a atteint un seuil suffisant.

Les figures qui suivent décrivent plus en détail différents modes de réalisation possibles du récupérateur d'énergie adaptés à différent type d'énergie à récupérer.

La figure 2 représente plus en détail un premier mode de réalisation du générateur 2 dans le cas où la source 4 est une source de champ magnétique variable. L'amplitude des composantes B_{X} et B_{Y} du champ magnétique variable, respectivement, parallèles à des directions X et Y, varie au cours du temps. Ici, les directions X et Y sont orthogonales entre elles et horizontales. Dans ce mode de réalisation particulier, les variations des composantes B_{X} et B_{Y} sont déphasées temporellement l'une par rapport à l'autre d'une valeur prédéterminée. Dans cet exemple, ce déphasage est égal à 90° et les composantes B_{X} et B_{Y} sont dites en opposition de phase.

Par exemple, la source 4 comporte un aimant permanent 8 dont le moment magnétique est horizontal et un moteur 10 entraînant en rotation l'aimant 8 autour d'un axe vertical parallèle à une direction Z. La direction Z est perpendiculaire aux directions X et Y.

Ici, le convertisseur 20 génère un excédent de charges électriques sur la borne 22 proportionnel à la valeur absolue de l'amplitude de la composante B_{X}. Il génère également un excédent de charges électriques sur la borne 24 proportionnel à la valeur absolue de l'amplitude de la composante B_{Y}. Puisque l'amplitude des composantes B_{X} et B_{Y} sont en opposition de phase, lorsque l'excédent de charges électriques est maximal sur la borne 22, il est minimal sur la borne 24 et vice versa.

De préférence, le convertisseur 20 est disposé à proximité de la source 4. Par exemple, la distance la plus courte entre le convertisseur 20 et la source 4 est inférieure à 10 cm et, de préférence, inférieure à 1 cm.

Le convertisseur 20 est aussi apte à stocker les charges électriques produites sur les bornes 22 et 24 lorsque ces bornes sont électriquement isolées de tout autre circuit électrique extérieur susceptible de lui permettre de se décharger. Ainsi, le convertisseur 20 fonctionne aussi comme un condensateur. Par exemple, en absence de raccordement à un circuit électrique extérieur, l'excédent de charges présent sur la borne 22 ou 24 varie de moins de 50 % en plus de 1 ms et, de préférence, en plus de 1 s ou 1 mn ou 1 h.

Le convertisseur 20 est décrit plus en détail en référence à la figure 3.

Le circuit 30 comprend deux bornes 40 et 42 d'entrée directement raccordées, respectivement, aux bornes 22 et 24. Le circuit 30 comprend également deux bornes 44 et 46 de sortie directement raccordées, respectivement, à des bornes 49A et 49B du condensateur 3.

Ici, on dit que des éléments A et B sont « directement raccordés » lorsqu'il existe une liaison électrique raccordant ces éléments A et B qui ne passent pas par l'intermédiaire d'un autre composant électrique tel qu'un autre interrupteur, une autre diode ou une inductance. De plus, dans cette description, à défaut de précision contraire, le terme « raccorder » signifie « raccorder électriquement ».

Le circuit 30 est conçu pour transférer les charges électriques accumulées sur les bornes 22 et 24 vers la borne 44 de sortie. A cet effet, il comporte :
- un interrupteur mécanique 48 directement raccordé d'un côté à la borne 40 et de l'autre côté à l'anode d'une diode 50,
- un interrupteur mécanique 52 directement raccordé d'un côté à la borne 42 et de l'autre côté à l'anode de la diode 50,
- un interrupteur mécanique 54 directement raccordé d'un côté à la borne 40 et de l'autre côté directement à la borne 46, et
- un interrupteur mécanique 56 directement raccordé d'un côté à la borne 42 et de l'autre côté à la borne 46.

La cathode de la diode 50 est électriquement raccordée à la borne 44 par l'intermédiaire d'une inductance 58.

Le circuit 30 comporte également une diode 60 dont la cathode est directement raccordée entre la cathode de la diode 50 et l'inductance 58 et dont l'anode est directement raccordée à la borne 46. Les interrupteurs 48, 52, 54 et 56 sont aptes à commuter entre une position fermée dans laquelle ils conduisent l'électricité et une position ouverte dans laquelle ils ne conduisent pas l'électricité. La commutation de ces interrupteurs entre leurs positions fermée et ouverte est commandée par le dispositif 34 de commande. Un mode de réalisation de ces interrupteurs est décrit plus en détail en référence à la figure 4.

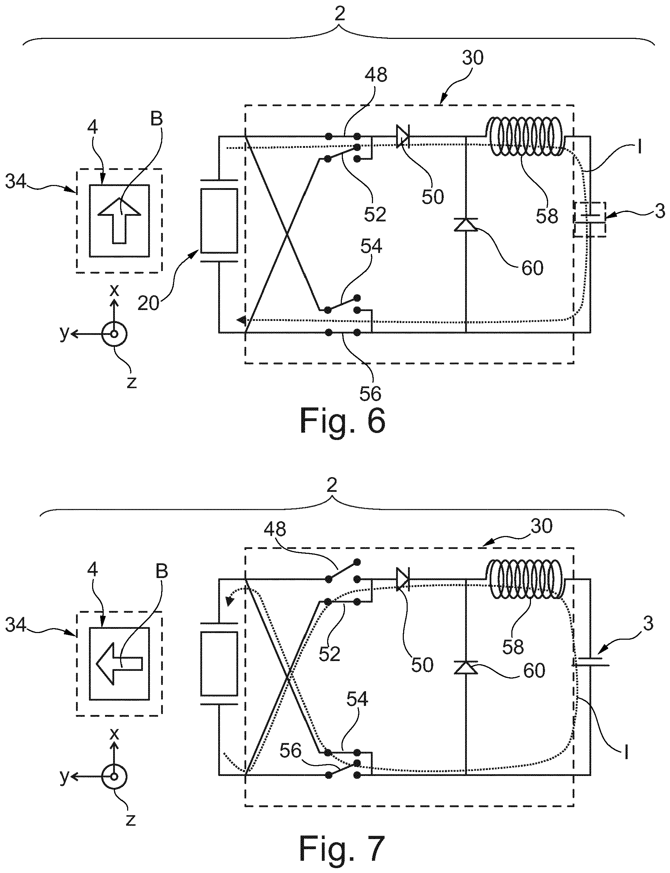

Le dispositif 34 commande la commutation des interrupteurs du circuit 30 pour passer, en alternance, entre :
- une première position de décharge, représentée sur la figure 6, dans laquelle l'excédent de charges électriques accumulé sur la borne 22 est transféré vers la borne 44,
- une seconde position de décharge, représentée sur la figure 7, dans laquelle l'excédent de charges électriques accumulé sur la borne 24 est transféré vers la borne 44, et
- une position de repos, représentée sur la figure 2, dans laquelle les bornes 22 et 24 sont électriquement isolées de tout autre circuit électrique de manière à permettre l'accumulation des charges électriques entre ces bornes.

Plus précisément, le dispositif 34 est conçu pour :
- commander le passage vers la première position de décharge uniquement lorsque l'excédent de charges accumulé sur la borne 22 dépasse un premier seuil prédéterminé S₁,
- commander le passage vers la seconde position de décharge uniquement lorsque l'excédent de charges accumulé sur la borne 24 dépasse un second seuil prédéterminé S₂, et
- commander le passage dans la position de repos tant que l'excédent de charges électriques accumulé sur la borne 22 est inférieur au seuil S₁ et sur la borne 24 est inférieur au seuil S₂.

A cet effet, le dispositif 34 est ici uniquement composé de la source 4 d'énergie à récupérer. Autrement dit, dans ce mode de réalisation particulier, la source 4 d'énergie à récupérer et le dispositif 34 de commande ne sont qu'un seul et même élément.

La figure 3 représente plus en détail le convertisseur 20. Ce convertisseur 20 est capable de transformer en électricité des variations très lentes de l'énergie à récupérer. Par « variation lente », on désigne des variations dont la fréquence fondamentale est inférieure à 1 Hz ou 100 Hz. A cet effet, le convertisseur 20 convertit une variation de l'amplitude du champ magnétique variable dans une direction donnée en une génération d'un excédent de charges sur la borne 22 et, en alternance, sur la borne 24. Cette conversion se fait presque instantanément de sorte que la tension entre les bornes 22 et 24 varie en même temps et au fur et à mesure que l'amplitude du champ magnétique variable varie dans une direction donnée.

Dans ce mode de réalisation, le convertisseur 20 comporte un transducteur magnétique associé à un transducteur électromécanique. Le transducteur magnétique est une couche 70 en matériau magnétostrictif. Le transducteur électromécanique comprend ici une couche supérieure 72 et une couche inférieure 74 en matériau piézoélectrique. Les couches 72, 74 sont directement fixées sans aucun degré de liberté, respectivement, sur le dessus et le dessous de la couche 70. Ici, les couches 70, 72 et 74 s'étendent le long d'une direction longitudinale parallèle à la direction X.

La couche 70 est réalisée dans un matériau magnétostrictif dont la valeur absolue du coefficient de magnétostriction λₛ est supérieure à 10 ppm (partie par million) et de préférence supérieure à 100 ou 1000 ppm. Le coefficient λₛ est défini par la relation suivante : λₛ = ΔL/L, où :
- ΔL est le taux d'élongation du matériau magnétostrictif dans une direction donnée, et
- L est la longueur de ce matériau dans cette direction en absence de champ magnétique extérieur.

Ici le coefficient λₛ est positif. Par exemple, le matériau magnétostrictif est le Terfenol-D ou le FeSiB.

Les couches piézoélectriques sont directement collées de part et d'autre de la couche 70. Par exemple, le coefficient de couplage k de ces couches piézoélectriques est supérieur à 5 % ou 10 %. Ce coefficient de couplage est défini dans la norme ANSI/IEEE 176-1987 « ANSI/IEEE standard on piezoelectricity » ou dans les normes de la famille EN50324. Par exemple, le matériau piézoélectrique utilisé est le PZT (PbZtₓTi₁₋ₓO₃) ou autres.

Pour plus de détails sur le convertisseur 20, le lecteur peut se référer à l'article A1 suivant :
T. Lafont, J. Delamare, G. A. Lebedev, D. I. Zakharov, B. Viala, O. Cugat, L. Gimeno, N. Galopin, L. Garbuio et O. Geoffroy, « Magnetostrictive-piezoelectric composite structures for energy harvesting », Journal of michromechanics and microengeneering, n°22, 094009, (2012).

La couche 70 permet de générer une contrainte de plusieurs dizaines de MPa sur les couches piézoélectriques 72 et 74 qui génèrent, en réponse, une tension de plusieurs dizaines de volts entre les bornes 22 et 24. Typiquement, la tension maximale générée entre les bornes 22 et 24 dépasse 200 Vdc. Il a été mesuré que l'énergie produite par un tel convertisseur peut être supérieure à 50 µJ et, de préférence, supérieure à 100 µJ en réponse à une rotation d'un quart de tour de l'aimant 8.

La figure 4 représente plus en détail un mode de réalisation possible de l'interrupteur 48. Ici, l'interrupteur 48 est un interrupteur magnétique. Plus précisément, dans le cas particulier représenté, l'interrupteur 48 est un interrupteur connu sous le terme d'interrupteur « Reed ». Il comporte deux plots électriques 80 et 82 raccordés électriquement chacun à une lame mobile respective 84 et 86. Les lames 84, 86 se terminent chacune par un contact électrique, respectivement, 84A et 86A. Les lames 84, 86 sont aptes à déplacer les contacts 84A et 86A entre :
- une position ouverte dans laquelle ils sont mécaniquement séparés l'un de l'autre par un milieu isolant pour isoler électriquement les plots 80 et 82, et
- une position fermée dans laquelle ils sont directement mécaniquement en appui l'un sur l'autre pour raccorder électriquement les plots 80 et 82.

Le milieu isolant est par exemple un gaz ou un liquide électriquement isolant ou un gaz sous très faible pression, c'est-à-dire une pression inférieure à 10⁵ Pa ou 100 Pa ou 0,1 Pa.

Les plots 80, 82 sont raccordés au reste du circuit 30.

Les lames 84 et 86 sont réalisées en matériau magnétique. Par exemple, le matériau magnétique présente une perméabilité relative supérieure à 100 ou 1000 pour une fréquence nulle du champ magnétique. Elles s'étendent essentiellement parallèlement à une direction d'actionnement commune représentée par une flèche Fₐ sur la figure 4.

Lorsque le champ magnétique, au niveau de l'interrupteur 48, atteint une configuration d'actionnement, la force exercée par ce champ magnétique permet de déplacer les contacts 84A et 86A de la position ouverte vers la position fermée. A l'inverse, en dehors d'une configuration d'actionnement, le champ magnétique au niveau de l'interrupteur est insuffisant pour garder les contacts 84A, 86A en position fermée.

L'homme du métier sait que les cartographies de champ magnétique autour d'un aimant ne se limite pas à une direction unique et que la sensibilité d'un interrupteur magnétique est complexe notamment en termes d'amplitude, de direction et de réversibilité (ou d'hystéresis). Toutefois, il sait adapter la position de l'aimant et du relais en conséquence. Ainsi, dans la suite de cette description, pour simplifier, on considère qu'une configuration d'actionnement est atteinte lorsque l'amplitude du champ magnétique, au niveau de l'interrupteur 48, dépasse un seuil de commutation S_{c} dans la direction Fₐ. A l'inverse, on considère, toujours pour simplifier, que si l'amplitude du champ magnétique parallèle à la direction Fₐ est inférieure à ce seuil S_{c}, alors les contacts 84A et 86A se déplacent, par déformation élastique des lames 84, 86, de leur position fermée vers la position ouverte puis restent dans la position ouverte. L'interrupteur 48 est donc un interrupteur normalement ouvert. La valeur du seuil S_{c} au-delà duquel l'interrupteur 48 commute de sa position ouverte vers sa position fermée détermine la sensibilité de l'interrupteur 48 au champ magnétique. L'interrupteur 48 est fixé sans aucun degré de liberté par rapport à la source 4. Dans le cas de l'interrupteur 48, sa direction d'actionnement est parallèle à la direction X. De plus, sa sensibilité est choisie pour que les contacts 84A et 86A se déplacent de la position ouverte vers la position fermée uniquement au moment où l'amplitude de la composante B_{X} atteint une amplitude correspondant à un excédent de charges sur la borne 22 supérieur au seuil S₁. Ainsi, la commutation de l'interrupteur 48 est directement commandée par la source 4. Plus précisément, dans le cas de la source 4 et du convertisseur 20, l'excédent de charges électriques sur la borne 22 est maximal quand le moment magnétique de l'aimant 8 est parallèle à la direction X. Ainsi, la sensibilité de l'interrupteur 48 est choisie pour que celui-ci commute vers la position fermée uniquement lorsque le moment magnétique de l'aimant 8 est aligné sur la direction X à plus ou moins 30° près et, de préférence, à plus ou moins 5° près. L'interrupteur 56 est identique à l'interrupteur 48. Les interrupteurs 52 et 54 sont identiques à l'interrupteur 48 sauf que leurs directions d'actionnement sont parallèles à la direction Y et non pas parallèles la direction X.

On notera qu'ici le décalage angulaire entre les directions d'actionnement des interrupteurs 48 et 56 et des interrupteurs 52 et 54 est égal à la valeur du déphasage angulaire entre la variation de l'excédent de charges électriques sur les bornes 22 et 24.

Le fonctionnement du générateur 2 va maintenant être décrit à l'aide du procédé de la figure 5 et en référence aux figures 6 et 7.

Lors d'une étape 90, en permanence, la source 4 génère le champ magnétique variable. Ici, seule la direction du champ magnétique varie au cours du temps de sorte que les amplitudes des composantes B_{X} et B_{Y} sont déphasées d'un angle de 90°.

En parallèle, lors d'une étape 92, le convertisseur 20 convertit en permanence la variation du champ magnétique variable en une variation correspondante de la quantité de charges sur ses bornes 22 et 24.

En parallèle de ces étapes 90 et 92, on procède à la commande du circuit de collecte 30. Pour cela, plus précisément, le circuit 30 est commandé pour collecter l'excédent de charges électriques accumulé, en alternance, sur les bornes 22 et 24 uniquement au moment où l'excédent est maximal.

Initialement, le moment magnétique de l'aimant 8 est dans une direction intermédiaire entre les directions X et Y, c'est-à-dire ni parallèle à la direction X ni parallèle à la direction Y et tourne vers la direction X. Les amplitudes des composantes B_{X} et B_{Y} sont alors inférieures au seuil de commutation S_{c} des interrupteurs. Dans cet état, lors d'une étape 96, la source 4 commande la commutation des interrupteurs 48, 52, 54 et 56 vers la position ouverte puis maintient ces interrupteurs dans la position ouverte. Le circuit de collecte est donc dans sa position de repos représentée sur la figure 2. Dans cette position de repos, les bornes 22 et 24 sont électriquement isolées des bornes 44 et 46. Les charges produites par le convertisseur 20 s'accumulent donc sur la borne 22.

Ensuite, la direction de l'aimant 8 devient parallèle à la direction X. L'excédent de charges accumulé sur la borne 22 est maximal. En effet, lorsque le moment de l'aimant 8 est parallèle à la direction X, cela correspond à une déformation maximale de la couche 70 dans la direction X. A ce moment-là l'amplitude de la composante Bx dépasse le seuil de commutation S_{c} des interrupteurs 48 et 56. Lors d'une étape 98, la source 4 commande alors la commutation de ces interrupteurs 48, 56 vers leur position fermée. Le circuit 30 passe dans sa première position de décharge représentée sur la figure 6. Les charges électriques présentes sur la borne 22 sont transférées vers le condensateur 3 qui les stocke. Sur les figures 6 et 7, le sens de circulation du courant correspondant à ce transfert de charges électriques est représenté par une flèche I. Sur ces mêmes figures, la direction du moment magnétique de l'aimant 8 est représentée par une flèche B.

Ensuite, l'aimant 8 continue de tourner vers, cette fois-ci, la direction Y. La direction du moment magnétique de l'aimant 8 repasse donc dans une position intermédiaire. L'amplitude des composantes B_{X} et B_{Y} devient inférieure au seuil S_{c} des interrupteurs 48, 52, 54 et 56. Lors d'une étape 100, la source 4 commande alors la commutation des interrupteurs vers la position ouverte. Le circuit 30 retourne dans sa position de repos représentée sur la figure 2.

Enfin, lorsque le moment magnétique de l'aimant 8 devient parallèle à la direction Y, cela correspond à une déformation maximale de la couche 70 dans la direction Y et donc à un excédent maximum de charges sur la borne 24.

En même temps, l'amplitude de la composante B_{Y} dépasse le seuil S_{c} des seuls interrupteurs 52 et 54. Ainsi, lors d'une étape 102, la source 4 commande la fermeture de ces interrupteurs. Le circuit 30 passe dans sa seconde position de décharge représentée sur la figure 7. Dans cette position, les charges électriques accumulées sur la borne 24 sont transférées vers la borne 49A du condensateur 3 qui les stocke.

La direction du moment magnétique de l'aimant 8 continue à tourner pour se rapprocher de nouveau de la direction X. On retourne alors à l'étape 96.

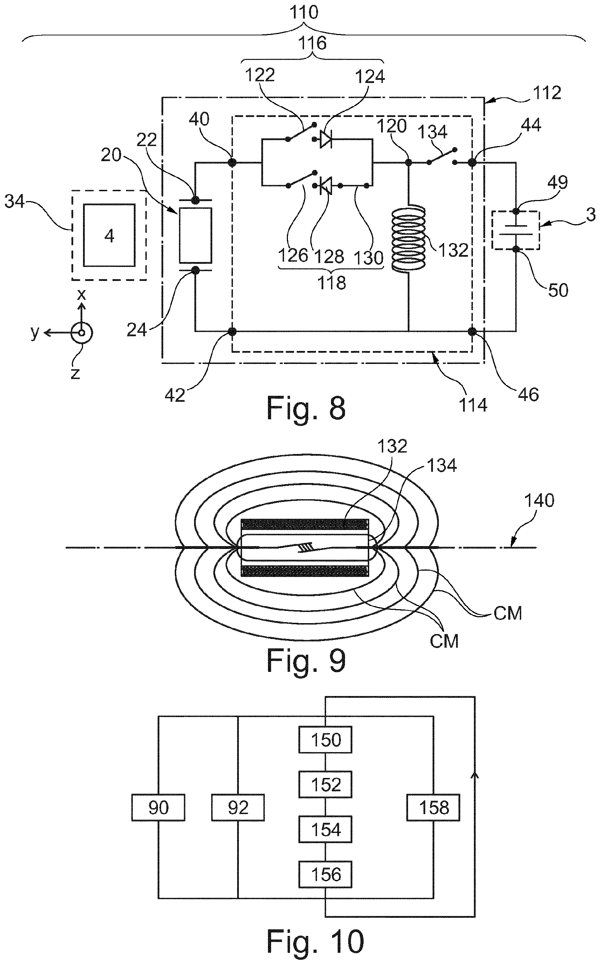

La figure 8 représente un générateur 110 identique au générateur 2 sauf que le récupérateur d'énergie 6 est remplacé par un récupérateur d'énergie 112. Le récupérateur 112 est identique au récupérateur 6 sauf que le circuit de collecte 30 est remplacé par un circuit de collecte 114.

Le circuit de collecte 114 comporte les mêmes bornes 40, 42 d'entrée et les mêmes bornes 44, 46 de sortie. Il comporte également deux branches 116 et 118 raccordées en parallèle entre les bornes 40 et un point 120 de raccordement. La branche 116 comporte un interrupteur 122 raccordé directement en série avec une diode 124. L'interrupteur 122 est par exemple identique à l'interrupteur 48. L'anode de la diode 124 est directement raccordée à l'interrupteur 122.

La branche 118 comporte un interrupteur 126 raccordé en série avec une diode 128 et un interrupteur magnétique 130. L'interrupteur 126 est par exemple identique à l'interrupteur 52. La cathode de la diode 128 est directement raccordée à l'interrupteur 126. L'anode de cette diode 128 est directement raccordée à l'interrupteur 130.L'interrupteur 130 est un interrupteur magnétique normalement fermé, c'est-à-dire que cet interrupteur 130 est dans la position ouverte tant que l'amplitude du champ magnétique le long de sa direction d'actionnement est inférieure à son seuil S_{c} de commutation.

Le point 120 est électriquement raccordé par l'intermédiaire d'une bobine 132 aux bornes 42 et 46. Ce point 120 est également raccordé par l'intermédiaire d'un interrupteur 134 de libération des charges accumulées à la borne 44.

La bobine 132 génère un champ magnétique proportionnel à l'intensité du courant qui la traverse et au nombre de spires qui la compose.L'interrupteur 134 est un interrupteur magnétique normalement ouvert qui commute systématiquement en position fermée quand l'interrupteur 130 commute vers la position ouverte et vice versa. Par exemple, à cet effet, les interrupteurs 130 et 134 présentent une lame magnétique commune.

Ici, les interrupteurs 130 et 134 sont placés dans le champ magnétique généré par la bobine 132 de manière à ce que la commutation de ces interrupteurs 130 et 134 soit uniquement commandée par le champ magnétique généré par cette bobine. Un exemple de positionnement de ces interrupteurs par rapport à la bobine est décrit plus en détail en référence à la figure 9.

Ici, la direction d'actionnement, le nombre de spires de la bobine 132, la sensibilité des interrupteurs 130 et 134 est déterminée, par exemple expérimentalement, pour que ces interrupteurs 130 et 134 commutent uniquement quand l'intensité du courant traversant la bobine 132 dépasse un seuil prédéterminé S_{b}. Ce seuil S_{b} est choisi pour correspondre à un seuil S₃ de l'excédent de charges électriques présent sur la borne 22 plusieurs fois supérieur au seuil S₁. En effet, l'intensité du courant dans la bobine 132 est directement proportionnelle à l'excédent de charges électriques accumulé entre les bornes 22 et 24.

La figure 9 représente plus en détail la bobine 132 et le positionnement de l'interrupteur 134 par rapport à cette bobine. Ici, la bobine 132 est bobinée autour d'un axe d'enroulement 140. L'interrupteur 134 est placé à l'intérieur des spires de la bobine 132 de manière à ce que sa direction d'actionnement soit confondue avec cet axe d'enroulement. Pour simplifier la figure 9, la position de l'interrupteur 130 n'a pas été représentée. L'interrupteur 130 est disposé de façon identique à ce qui a été décrit pour l'interrupteur 134. Sur la figure 9, les lignes du champ magnétique à l'extérieure de la bobine 132 sont représentées par des lignes CM.

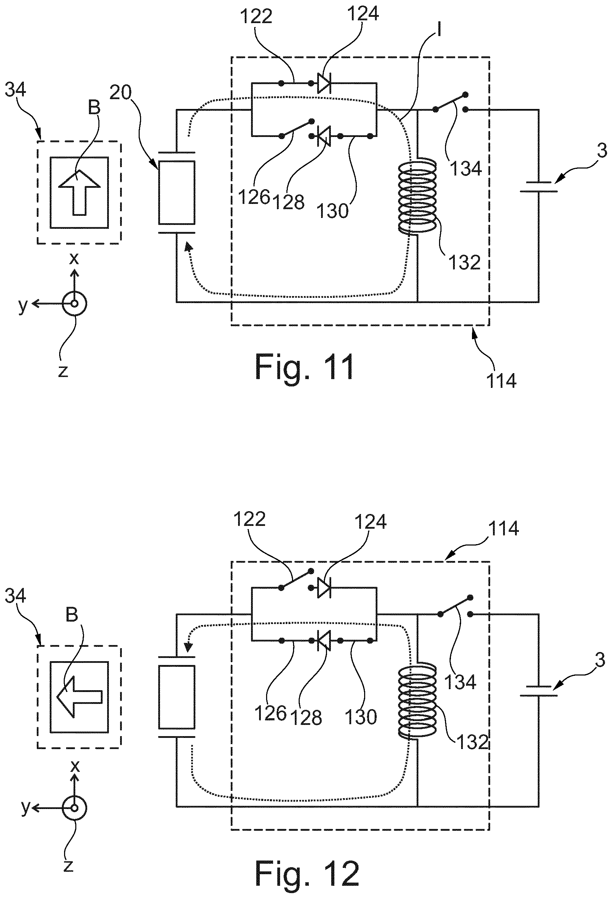

Le fonctionnement du générateur 110 va maintenant être décrit en référence au procédé de la figure 10 et à l'aide des figures 11 à 13. Le procédé de la figure 10 comporte les mêmes étapes 90 et 92 que le procédé de la figure 5.

La commande du circuit de collecte se déroule comme suit.

Initialement, on suppose que le convertisseur 20 est complètement déchargé et que la direction B du champ magnétique généré par la source 4 est dans une position intermédiaire entre les directions X et Y et se dirige vers la direction X. Dans ces conditions, l'amplitude des composantes B_{X} et B_{Y} est inférieure au seuil S_{c} des interrupteurs 122 et 126. Lors d'une étape 150, la source 4 commande alors la commutation de ces interrupteurs vers leur position ouverte. Le circuit 114 est alors dans sa position de repos représentée sur la figure 8. De façon similaire à ce qui a été précédemment décrit à l'aide du procédé de la figure 4, dans cette position de repos, le convertisseur 20 accumule un excédent de charges électriques qu'il produit sur la borne 22.

Ensuite, la direction B du champ magnétique devient parallèle à la direction X. En réponse, lors d'une étape 152, la source 4 commande la fermeture de l'interrupteur 122. Le circuit 114 passe alors dans sa première position de décharge représentée sur la figure 11. Les charges stockées sur la borne 22 sont transférées par l'intermédiaire de la bobine 132 vers la borne 24. Cela crée un courant qui traverse la bobine 132. La direction du courant qui circule dans le circuit 114 est représentée par une flèche I sur les figures 11 à 13. La direction du moment magnétique de l'aimant 8 est représentée par une flèche B sur ces mêmes figures.

Ensuite, la direction du moment magnétique de l'aimant 8 continue à tourner et s'éloigne de nouveau de la direction X pour se rapprocher de la direction Y. L'amplitude des composantes B_{X} et B_{Y} devient inférieure au seuil de commutation S_{c} des interrupteurs 122 et 126. La source 4 commande donc, lors d'une étape 154, la commutation de l'interrupteur 122 vers la position ouverte et maintient ensuite les interrupteurs 122 et 126 dans la position ouverte. On revient donc à la position de repos du circuit 114 représentée sur la figure 8. L'excédent de charges accumulé sur la borne 24 augmente au fur et à mesure que la direction B se rapproche de la direction Y. Toutefois, dans ce mode de réalisation, le nouvel excédent de charges produit s'accumule à l'excédent transféré lors de l'étape 152.

Ensuite, la direction B devient parallèle à la direction Y. L'amplitude de la composante B_{Y} est supérieure au seuil S_{c} de l'interrupteur 126. La source 4 commande alors, lors d'une étape 156, la commutation de cet interrupteur 126 vers la position ouverte. Le circuit 114 passe dans sa seconde position de décharge représentée sur la figure 12. Les charges stockées accumulées sur la borne 24 sont alors transférées vers la borne 22 par l'intermédiaire de la bobine 132.

Ensuite, la direction B s'éloigne à nouveau de la direction Y pour se rapprocher de la direction X. On retourne alors à l'étape 150.

Les étapes 150 et 156 sont réitérées plusieurs fois pour accroître l'excédent de charges stocké, en alternance, sur les bornes 22 et 24 et donc augmenter l'intensité du courant qui traverse la bobine 132 lors des étapes 152 et 156.

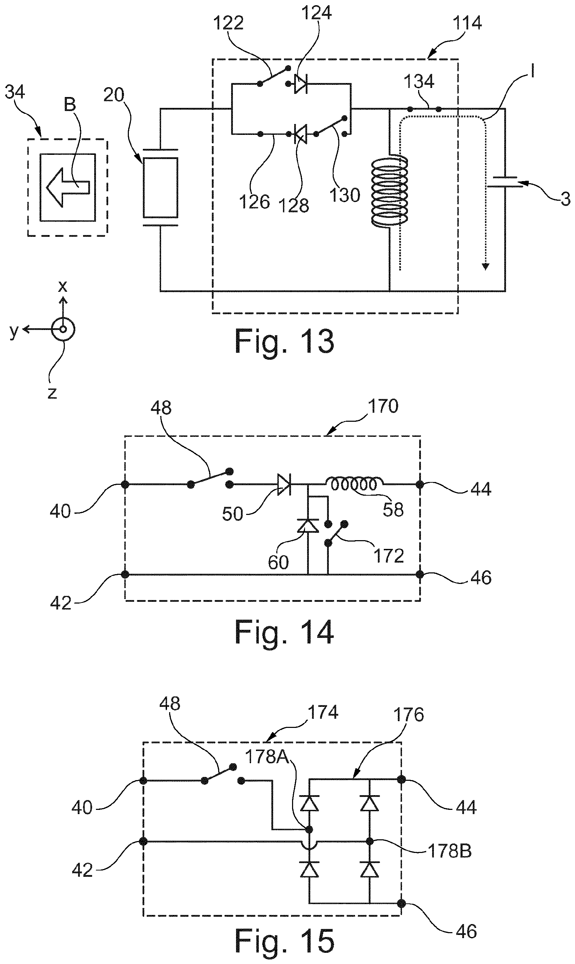

En parallèle, lors d'une étape 158, quand l'intensité du courant qui traverse la bobine 132 atteint le seuil S_{b}, la bobine 132 commande la commutation des interrupteurs 130 et 134 vers, respectivement, leur position ouverte et fermée. Le circuit 114 passe alors dans une position de libération de l'excédent de charges électriques accumulé vers le condensateur 3 représentée sur la figure 13. Les charges stockées par le convertisseur 20 sont alors transférées vers le condensateur 3.

La figure 14 représente un circuit 170 de collecte identique au circuit 30 sauf que les interrupteurs 52, 54 et 56 sont omis. Ce circuit 170 est plus simple à réaliser mais permet uniquement le transfert l'excédent de charges électriques produit par la déformation longitudinale maximale du convertisseur 20 et non plus lors de sa déformation transversale. De plus, de préférence, un interrupteur commandable 172 est raccordé en parallèle de la diode 60 pour éviter la chute de tension causée par cette diode. A cet effet, l'interrupteur 172 est commandé de manière :
- à se fermer en même temps que la diode 60 devient passante, et en alternance
- à s'ouvrir lorsque la diode 60 est non-passante.

Par exemple, l'interrupteur 172 est un interrupteur magnétique normalement ouvert dont la fermeture est commandée par une bobine de commande. La bobine de commande et l'interrupteur 172 peuvent être agencés comme décrit en référence à la figure 9. Ici, la bobine de commande est la bobine 58.

La figure 15 représente un circuit 174 de collecte identique au circuit 30 sauf que les interrupteurs 52, 54 et 56 et la diode 60 sont remplacés par un pont de diode 176 capable de redresser le courant généré par la décharge du convertisseur 20.

Le pont de diodes 176 comprend des première et seconde branches électriquement raccordées en parallèle entre les bornes 44 et 46. La première branche comporte deux diodes raccordées en série par l'intermédiaire d'un point milieu 178A. La seconde branche comporte aussi deux diodes raccordées en série par l'intermédiaire d'un point milieu 178B. Le point milieu 178A est directement raccordé en permanence à l'un des contacts électriques de l'interrupteur 48. Le point milieu 178B est raccordé en permanence à la borne 42 du circuit de collecte, par exemple, par l'intermédiaire d'une inductance non représentée sur la figure 15.

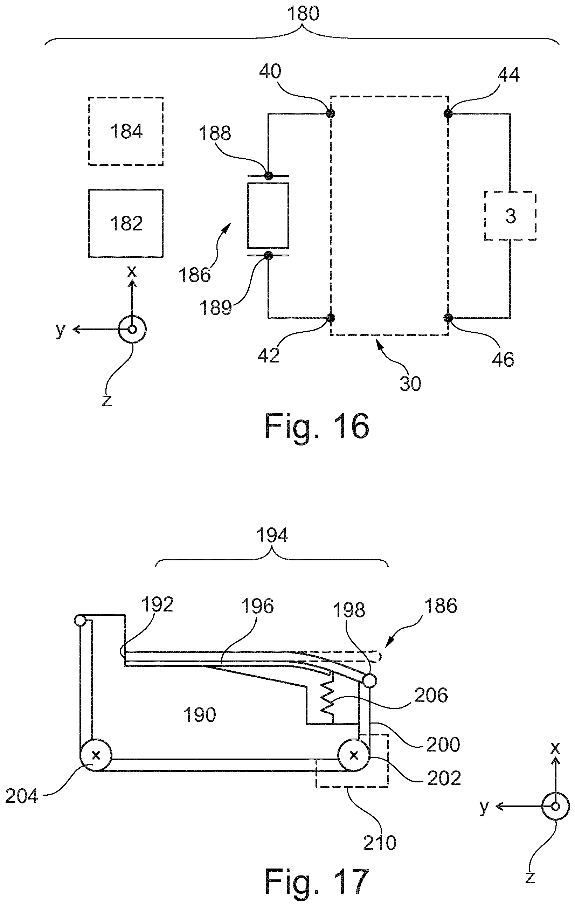

La figure 16 représente un générateur 180 d'électricité identique au générateur 2 sauf que :
- la source 4 est remplacée par une source 182 d'énergie à récupérer,
- le dispositif 34 de commande est remplacé par un dispositif 184 de commande, et
- le convertisseur 20 est remplacé par un convertisseur 186.

Ici, la source 182 d'énergie à récupérer est une source générant des variations de température du milieu ambiant dans lequel est plongé le convertisseur 186. Par exemple, il peut s'agir d'un objet chaud que l'on approche et, en alternance, que l'on éloigne du convertisseur 186 ou de la variation de température d'un objet. Ainsi, dans ce mode de réalisation, la source 182 ne génère pas directement le champ magnétique variable nécessaire pour commander les interrupteurs du circuit 30. Dans ce mode de réalisation, la source 182 et le dispositif 184 de commande du circuit 170 sont donc deux éléments distincts.

Le convertisseur 186 convertit la variation de température en un excédent correspondant de charges électriques sur une borne 188 et, en alternance, sur une borne 189. Ces bornes 188 et 189 sont directement raccordées aux bornes, respectivement, 40 et 42 du circuit 30 de collecte.

La figure 17 représente un mode de réalisation plus détaillé du dispositif 184 et du convertisseur 186.

Le convertisseur 186 comprend un châssis 190. Une extrémité proximale 192 d'une poutre 194 est ancrée sans aucun degré de liberté dans ce châssis 190. Cette poutre 194 comporte une plaque 196 en matériau piézoélectrique. Une extrémité distale 198 de la poutre 194 est reliée sans aucun degré de liberté à une extrémité d'un fil 200. La poutre 194 est déplaçable entre une position active, dans laquelle elle est courbée et une position de repos dans laquelle elle s'étend horizontalement dans le plan Y, Z. La position active est représentée en trait plein sur la figure 17 tandis que la position de repos est représentée en pointillé.

Une extrémité opposée du fil 200 est ancrée sans aucun degré de liberté au châssis 190. Entre ces deux extrémités, le fil 200 est reçu dans des gorges de deux poulies 202 et 204 dont les axes de rotation sont perpendiculaires aux directions X et Y et solidaires du châssis 190. Le fil 200 est réalisé dans un matériau à mémoire de forme. Ici, il s'agit d'un matériau à mémoire de forme présentant un taux d'allongement au moins supérieur à 1 % en réponse à une variation de température de 10° ou de 20°C. La composition du matériau à mémoire de forme est choisie pour que le fil passe de son état déployé à son état rétracté autour d'une de température de transition T_{f} comprise entre Tₘᵢₙ et Tₘₐₓ et, de préférence, égale à (Tₘᵢₙ+Tₘₐₓ)/2 à plus ou moins 15 ou 25 % près, où Tₘᵢₙ et Tₘₐₓ sont les températures, respectivement, minimale et maximale entre lesquelles varie la température de la source 182. L'assemblage de la plaque 196 avec le fil 200 est réalisé de telle sorte qu'à la température T_{f} presque aucune contrainte ne s'exerce sur la plaque 196. Ainsi, le convertisseur 186 génère un excédent de charges sur la borne 188 dans sa position active et un excédent de charges inverse sur la borne 189 dans la position de repos.

Un ressort 206 est également logé entre la poutre 194 et le châssis 190 pour solliciter cette poutre vers sa position de repos. Un tel convertisseur est décrit plus en détail dans l'article A2 de suivant :
D. Zakharov, G. Lebedev, O. Cugat, J. Delamare, B. Viala, T. Lafont, L. Gimeno et A. Shelyakov, « Thermal energy conversion by coupled shape memory and piezoelectric effects », PowerMEMS'11, Séoul, Corée, JMM 2012.

Le dispositif 184 de commande comporte un source de champ magnétique variable qui génère un champ magnétique parallèle à la direction X quand la poutre 194 est dans sa position active et parallèle à la direction Y quand la poutre 194 est dans sa position de repos. Pour faire cela sans consommer les charges produites par le convertisseur 186, la source de champ magnétique du dispositif 184 comporte un second convertisseur apte à générer le champ magnétique variable directement à partir de l'énergie à récupérer. Ce second convertisseur comporte :
- un transducteur thermomécanique apte à transformer la variation de température de la source 182 en une déformation de ce transducteur, et
- un aimant permanent 210 fixé, par l'intermédiaire d'une liaison mécanique, sur ce transducteur pour se déplacer en même temps que celui-ci se déforme.

Dans ce mode particulier de réalisation, le transducteur thermomécanique est le fil 200. Ainsi, le même transducteur thermomécanique est utilisé à la fois dans le convertisseur 186 et dans le dispositif 184 de commande.

A titre d'illustration, ici, l'aimant 210 est directement fixé sur la poulie 202 pour être entraîné en rotation par cette poulie entre une position où son moment magnétique est parallèle à la direction X et une position opposée où la direction de son moment magnétique est parallèle à la direction Y. Par exemple, le diamètre de la poulie 202 est choisi pour qu'elle fasse un quart de tour lorsque la poutre se déplace de sa position de repos jusqu'à sa position active. L'aimant 210 peut aussi être mécaniquement raccordé à la poulie 202 par un liaison mécanique qui amplifie le déplacement angulaire de cette poulie.

Le fonctionnement du circuit 30 de collecte est le même que précédemment. Ainsi, seuls les détails spécifiques au fonctionnement du générateur 180 sont donnés maintenant. Lorsque la température augmente, le fil 200 se rétracte. La poutre 194 se courbe alors vers sa position active. En réponse, la plaque 196 produit un excédent de charges électriques sur la borne 188. Lorsque la poutre 194 atteint sa position active, La direction du moment magnétique de l'aimant 210 est alignée sur la direction X. Ainsi, les charges produites par le convertisseur 186 sont transférées vers le condensateur 3 uniquement lorsque l'excédent de charges produit sur la borne 188 est proche de son maximum.

Quand la température diminue, le fil 200 se détend et, simultanément, l'aimant 210 tourne en sens inverse. Dans le même temps, le convertisseur 186 génère un excédent de charges électriques sur la borne 189. Quand la direction du moment magnétique de l'aimant 210 atteint la direction Y, l'excédent de charges électriques produit sur cette borne 189 est automatiquement transféré vers le condensateur 3.

De nombreux autres modes de réalisation sont possibles. Par exemple, le condensateur 3 peut être remplacé par une batterie. Le condensateur 3 peut aussi être remplacé par un élément électrique n'ayant pas la capacité de stocker de l'énergie électrique. Par exemple, le condensateur 3 est remplacé par une charge consommant l'énergie électrique reçue. Il peut s'agir d'une charge résistive. Dans ce dernier cas, les inductances 58 et 132 peuvent être omises.

### [Variantes de la source d'énergie à récupérer]

La source d'énergie à récupérer peut être aussi un déplacement mécanique d'une pièce tel qu'un bouton poussoir. Dans ce cas, le premier convertisseur peut ne comporter que le transducteur électromécanique directement relié à cette pièce pour que le déplacement de cette pièce fasse varier la contrainte mécanique qu'elle exerce sur ce transducteur électromécanique. Dans ce cas, le transducteur du dispositif de commande est par exemple réalisé en reliant mécaniquement un aimant permanent sur la pièce qui se déplace de sorte que ce déplacement de la pièce entraîne aussi le déplacement de cet aimant permanent et génère donc le champ magnétique variable qui commande la commutation des interrupteurs magnétiques. Les autres dispositifs de commande décrits précédemment peuvent également être mis en oeuvre.

Le champ magnétique variable généré par la source n'est pas nécessairement un champ magnétique généré par un aimant permanent monté en rotation sur un axe. Par exemple, ce qui a précédemment été décrit s'applique également au cas où seule l'amplitude de l'une des composantes B_{X} ou B_{Y} varie au cours du temps. Par exemple, cela peut être le cas si l'aimant permanent est monté sur une pièce qui se déplace uniquement en translation parallèlement à la direction X. La source d'énergie à récupérer qui génère le champ magnétique variable peut aussi être une bobine alimentée de temps en temps par un courant ou un simple conducteur électrique parcouru par un courant dont l'intensité varie au cours du temps.

### [Variantes du convertisseur]

D'autres modes de réalisation possibles du convertisseur 20 sont décrits dans l'article A1 précédemment référencé ou dans la demande US2004/0126620A1.

Le transducteur électromécanique du convertisseur 20 ne comporte pas nécessairement un matériau piézoélectrique. Par exemple, en variante, le transducteur électromécanique est réalisé à partir d'un condensateur dont la capacité varie en fonction d'un déplacement mécanique. Typiquement, le condensateur comporte deux électrodes mobiles séparées l'une de l'autre par un matériau diélectrique. Lorsque les électrodes se déplacent, la capacité du condensateur varie. Le déplacement des électrodes est actionné par :
- un matériau magnétostrictif, pour convertir une variation de champ magnétique en une variation de charges électriques, ou
- un transducteur thermomécanique, pour convertir une variation de température en une variation de charges électriques, ou
- un déplacement mécanique d'un bouton pour convertir un déplacement mécanique en une variation de charges électriques.

Dans une mode particulier de réalisation, les électrodes du condensateur sont réalisées dans un matériau magnétostrictif. Dans ce cas, une variation de l'amplitude du champ magnétique dans une direction donnée entraîne une variation de la surface des électrodes et donc de la capacité de ce condensateur.

Dans une autre variante, on choisit pour le condensateur des électrodes standard et un diélectrique dont la permittivité varie en fonction du champ magnétique. Il peut s'agir par exemple de BiFeO₃. Dans ce cas également, une variation du champ magnétique entraîne une variation de la capacité du condensateur.

La variation de la capacité du condensateur est ensuite transformée en une génération de charges électriques par un dispositif électronique comme, par exemple, un dispositif mettant en oeuvre des électrets. La génération d'électricité à partir d'une variation de capacité et à l'aide d'électrets est par exemple décrite dans l'article suivant :
S. Boisseau, G. Despesse et A. Sylvestre, « Optimization of an electret-based energy harvester », Smart Material and Structures, 2010, 19 075015, IOP Publisching Ltd.

Le matériau magnétostrictif du convertisseur 20 peut aussi être un matériau à coefficient de magnétostriction négatif. Il peut aussi s'agir d'un matériau dont le coefficient de magnétostriction est isotrope ou anisotrope.

Le convertisseur 20 peut comporter plusieurs assemblages de transducteurs raccordés en parallèle entre les bornes de raccordement de ce convertisseur. Par exemple, le convertisseur 20 peut comporter un second assemblage identique à celui décrit en référence à la figure 3 mais dont la direction longitudinale est décalée angulairement dans le plan horizontal par rapport à la direction longitudinale du premier assemblage. Si les directions longitudinales de ces assemblages sont décalées de 90°, le circuit de collecte et le dispositif de commande fonctionnent comme précédemment décrit. Si les directions longitudinales sont décalées d'un angle α différent de 90°, la direction d'actionnement des interrupteurs 52, 54 doit être décalée, dans le plan XY par rapport à la direction d'actionnement des interrupteurs 48, 56 du même angle α. On comprend donc sur cet exemple que l'angle α entre les directions d'actionnement des interrupteurs magnétiques est choisi en fonction du déphasage entre les variations de l'excédent de charges électriques produit par le convertisseur.

D'autres modes de réalisation du convertisseur 186 sont possibles. Par exemple, d'autres modes de réalisation sont décrits dans l'article A2 précédemment référencé. D'autres modes de réalisation peuvent également être trouvés dans les demandes US 2011/0083714 ou US 7 397 169. Le convertisseur 186 peut également utiliser en tant que transducteur thermomécanique un bilame tel qu'un bilame cuivre-aluminium.

[Variantes des circuits de collecte et des dispositifs de commande]

Les circuits de collecte et les dispositifs de commande précédents ont été décrits dans le cas particulier où l'on collecte les charges électriques sur la borne 22 de raccordement uniquement lorsque la direction du moment magnétique de l'aimant 8 est parallèle à la direction d'actionnement de l'interrupteur 48. En variante, les circuits de collecte et les dispositifs de commande sont adaptés pour collecter les charges sur la borne 22 pour plusieurs directions différentes du moment magnétique de l'aimant 8, de préférence, uniformément réparties sur un secteur angulaire de 180°. Pour cela, des interrupteurs magnétiques supplémentaires sont raccordés en parallèle, respectivement, des interrupteurs 48 et 56. Ces interrupteurs magnétiques supplémentaires sont identiques, respectivement, aux interrupteurs 48 et 56 sauf que leur direction d'actionnement est décalée angulairement d'un angle β par rapport à la direction d'actionnement des interrupteurs 48, 56. Par exemple, si des interrupteurs magnétiques ayant une direction d'actionnement décalée de 45° par rapport à la direction X sont raccordés en parallèle des interrupteurs 48 et 56, les charges accumulées sur la borne 22 sont déchargées vers le condensateur 3 :
- lorsque le champ créé par l'aimant 8 au niveau des interrupteurs fait un angle de 45° avec la direction X, et
- lorsque le champ créé par l'aimant 8 au niveau des interrupteurs est parallèle à la direction X.

Une autre solution pour obtenir un fonction similaire à celle décrite ci-dessus, sans modifier le circuit de collecte, consiste à remplacer l'aimant 8 par un aimant multipolaire présentant des moments magnétiques dans plusieurs directions différentes. Dans ce cas, l'interrupteur 48 se ferme pour plusieurs angles de rotation de l'aimant multipolaire compris entre 0° et 180°. On peut aussi obtenir le même fonctionnement avec un aimant unipolaire qui fait plusieurs tours complets sur lui-même alors que le transducteur du dispositif de commande se déforme toujours dans le même sens. Par exemple, le diamètre de la poulie 202 est choisi de manière à ce que l'aimant 210 fasse un ou plusieurs tours complets sur lui-même lors d'un seul déplacement de la poutre 194 de sa position active vers sa position de repos.Les interrupteurs 130 et 134 ne sont pas nécessairement à l'intérieur de la bobine 132. En variante, ils sont placés dans le champ de cette bobine 132 mais à l'extérieur des spires formant cette bobine.

Dans le circuit de collecte 170, la diode 50 peut être omise.

Le dispositif 184 a été décrit dans le cas particulier où c'est le transducteur thermomécanique qui déplace l'aimant permanent. En variante, le transducteur thermomécanique déplace les interrupteurs du circuit 30 et non pas l'aimant permanent.

Les différents modes de réalisation du circuit de collecte décrits dans le cas du convertisseur 20 peuvent aussi être associés au convertisseur 186 ou tout autre convertisseur d'une énergie à récupérer en une variation de charges électriques stockées entre des bornes de raccordement.

Le dispositif 184 a été décrit dans le cas particulier où il utilise le même transducteur magnétique ou thermomécanique que celui utilisé par le convertisseur. En variante, le dispositif de commande comprend son propre transducteur magnétique ou thermomécanique mécaniquement indépendant de celui utilisé par le convertisseur de l'énergie à récupérer. Dans ce cas, le dispositif de commande peut être dépourvu de transducteur électromécanique apte à générer des charges électriques. Par exemple, ce transducteur comporte uniquement un matériau à mémoire de forme ou un matériau magnétostrictif.

Le matériau à mémoire de forme utilisé dans le mode de réalisation de la figure 17 pour réaliser le convertisseur et le dispositif de commande peut être remplacé par un matériau à fort coefficient de dilatation pour former un bilame avec la couche en matériau piézoélectrique. Dans une autre variante, le matériau à mémoire de forme est remplacé par un matériau magnétostrictif pour générer des charges électriques et commander les interrupteurs du circuit de collecte à partir d'une variation de champ magnétique.

### [Variantes d'interrupteurs]

De nombreux modes de réalisation sont possibles pour les interrupteurs magnétiques. Par exemple, les interrupteurs magnétiques peuvent aussi être réalisés comme décrits dans la demande FR 2 912 128. Dans un autre mode de réalisation, seule une des lames 84 ou 86 est mobile. De préférence, ces interrupteurs sont réalisés dans un même substrat.

Un blindage magnétique, notamment autour des interrupteurs 130 et 134, peut être prévu. De même, un blindage magnétique peut être prévu autour de l'ensemble des interrupteurs pour les isoler des champs magnétiques autres que ceux générés par la source d'énergie à récupérer.

Il est aussi possible de prévoir un guide de flux magnétique pour guider et concentrer le flux magnétique de la source de champ magnétique vers les interrupteurs magnétiques. Par exemple, le guide de flux magnétique est un noyau magnétique.

Les interrupteurs 130, 134, 172 ou la diode 60 peuvent être remplacés par des interrupteurs électroniques tels que des transistors ou thyristors.

Quel que soit l'interrupteur mécanique considéré, les contacts électriques de cet interrupteur ne se matérialisent pas nécessairement par un plot électrique en saillie. Par exemple, le contact électrique peut aussi être une région de l'élément qui se déforme ou se déplace et qui vient en appui mécanique sur l'autre contact électrique pour établir la continuité électrique.

Les circuits de collecte décrits ici peuvent être réalisés avec tout type d'interrupteurs commandables et pas seulement des interrupteurs magnétiques. Si les interrupteurs ne sont pas des interrupteurs magnétiques, la commande de ces interrupteurs peut être réalisée de façon classique pour fonctionner comme décrit ci-dessus.

## Revendications

1. Un générateur d'électricité comportant :
- un premier convertisseur (20) équipé de première et seconde bornes (22, 24) de raccordement, ce premier convertisseur étant apte à convertir une variation d'une énergie à récupérer en un excédent correspondant de charges électriques sur la première borne de raccordement par rapport à la seconde borne,
- un circuit (30 ; 114 ; 170 ; 174) de collecte de l'excédent de charges électriques sur la première borne de raccordement, ce circuit étant équipé :
• d'une borne (40) de sortie par l'intermédiaire de laquelle sont délivrées les charges collectées, et
• d'un premier interrupteur mécanique commandable (48 ; 122) raccordé à la première borne de raccordement, ce premier interrupteur étant apte à commuter entre une position ouverte dans laquelle il empêche la décharge des charges électriques à travers la première borne de raccordement et une position fermée dans laquelle il autorise la décharge des charges électriques à travers la première borne de raccordement, la position fermée dans l'interrupteur mécanique étant obtenue par la mise en appui d'un contact électrique directement sur un autre contact électrique de manière à établir une continuité électrique et la position ouverte étant obtenue par la séparation mécanique de ces deux contacts électriques et l'interposition entre ces deux contacts électriques d'un milieu électriquement isolant, et
- un dispositif (34) de commande du premier interrupteur propre à commander la commutation de cet interrupteur vers sa position fermée quand l'excédent de charges électriques présent sur la première borne de raccordement dépasse un premier seuil prédéterminé,
dans lequel :
- le premier interrupteur (48 ; 122) est un interrupteur magnétique, chaque interrupteur magnétique comportant au moins une lame (84, 86) en matériau magnétique apte à déplacer les contacts électriques de la position ouverte vers la position fermée lorsque le champ magnétique au niveau de l'interrupteur est dans une configuration d'actionnement, l'interrupteur magnétique étant incapable de garder ses contacts électriques dans la position fermée en dehors d'une configuration d'actionnement du champ magnétique au niveau de l'interrupteur magnétique, et
- le dispositif (34) de commande comporte une source de champ magnétique variable, le premier interrupteur étant disposé par rapport à cette source de manière à ce que le champ magnétique variable qu'elle génère au niveau de cet interrupteur atteigne une configuration d'actionnement du premier interrupteur uniquement au moment où l'excédent de charges électriques présent sur la première borne de raccordement dépasse le premier seuil prédéterminé,
**caractérisé en ce que** le premier convertisseur (20) est apte à convertir une variation d'un champ magnétique en un excédent correspondant de charges électriques sur la première borne de raccordement par rapport à la seconde borne et le premier convertisseur est placé dans les lignes de champ de la source de champ magnétique variable pour convertir ces variations de champ magnétique en excédent correspondant de charges électriques sur la première borne de raccordement de sorte que la source d'énergie à récupérer est la source de champ magnétique variable.

2. Le générateur selon la revendication 1, dans lequel :
- la source (4) de champ magnétique variable est apte à générer un champ magnétique variable dont le moment magnétique varie au cours du temps entre une première et une seconde positions,
- le premier convertisseur (20) est apte à convertir le champ magnétique variable en un excédent de charges électriques sur la première borne de raccordement dépassant le premier seuil prédéterminé pour la première position du moment magnétique, et en un excédent de charges électriques sur la seconde borne de raccordement dépassant un second seuil prédéterminé pour la seconde position du moment magnétique,
- le circuit (30) de collecte comporte un second interrupteur magnétique commandable (52 ; 126) raccordé à la seconde borne de raccordement, ce second interrupteur étant apte à commuter entre sa position ouverte dans laquelle il empêche la décharge des charges électriques à travers la seconde borne de raccordement et sa position fermée dans laquelle il autorise la décharge des charges électriques à travers la seconde borne de raccordement, le second interrupteur étant disposé par rapport à cette source de manière à ce que le champ magnétique variable qu'elle génère au niveau de ce second interrupteur atteigne une configuration d'actionnement du second interrupteur uniquement au moment où l'excédent de charges électriques présent sur la seconde borne de raccordement dépasse le second seuil prédéterminé, les configurations d'actionnement des premier et second interrupteurs étant distinctes.

3. Le générateur selon l'une quelconque des revendications 1 à 2, dans lequel, le premier convertisseur (20) comporte :
- un transducteur électromécanique (72, 74) apte à transformer directement une contrainte mécanique exercée sur ce transducteur électromécanique en un excédent de charges électriques collecté par le circuit électrique de collecte, et
- un transducteur magnétique (70) fixé sans aucun degré de liberté au transducteur électromécanique, ce transducteur magnétique comportant un matériau magnétostrictif apte à convertir une variation du champ magnétique variable en une contrainte mécanique exercée sur le transducteur électromécanique.

4. Un générateur d'électricité comportant :
- un premier convertisseur (186) équipé de première et seconde bornes (188) de raccordement, ce premier convertisseur étant apte à convertir une variation d'une énergie à récupérer en un excédent correspondant de charges électriques sur la première borne de raccordement par rapport à la seconde borne,
- un circuit (30 ; 114 ; 170 ; 174) de collecte de l'excédent de charges électriques sur la première borne de raccordement, ce circuit étant équipé :
• d'une borne (40) de sortie par l'intermédiaire de laquelle sont délivrées les charges collectées, et
• d'un premier interrupteur mécanique commandable (48 ; 122) raccordé à la première borne de raccordement, ce premier interrupteur étant apte à commuter entre une position ouverte dans laquelle il empêche la décharge des charges électriques à travers la première borne de raccordement et une position fermée dans laquelle il autorise la décharge des charges électriques à travers la première borne de raccordement, la position fermée dans l'interrupteur mécanique étant obtenue par la mise en appui d'un contact électrique directement sur un autre contact électrique de manière à établir une continuité électrique et la position ouverte étant obtenue par la séparation mécanique de ces deux contacts électriques et l'interposition entre ces deux contacts électriques d'un milieu électriquement isolant, et
- un dispositif (184) de commande du premier interrupteur propre à commander la commutation de cet interrupteur vers sa position fermée quand l'excédent de charges électriques présent sur la première borne de raccordement dépasse un premier seuil prédéterminé,
dans lequel :
- le premier interrupteur (48 ; 122) est un interrupteur magnétique, chaque interrupteur magnétique comportant au moins une lame (84, 86) en matériau magnétique apte à déplacer les contacts électriques de la position ouverte vers la position fermée lorsque le champ magnétique au niveau de l'interrupteur est dans une configuration d'actionnement, l'interrupteur magnétique étant incapable de garder ses contacts électriques dans la position fermée en dehors d'une configuration d'actionnement du champ magnétique au niveau de l'interrupteur magnétique, et
- le dispositif (184) de commande comporte une source de champ magnétique variable, le premier interrupteur étant disposé par rapport à cette source de manière à ce que le champ magnétique variable qu'elle génère au niveau de cet interrupteur atteigne une configuration d'actionnement du premier interrupteur uniquement au moment où l'excédent de charges électriques présent sur la première borne de raccordement dépasse le premier seuil prédéterminé,
**caractérisé en ce que** la source de champ magnétique variable comporte un second convertisseur supplémentaire comprenant :
• au moins un aimant permanent (210),
• un transducteur (200) apte à transformer la variation de l'énergie à récupérer en une déformation mécanique de ce transducteur, et
• une liaison mécanique entre l'aimant permanent et ce transducteur apte à faire varier la position relative de l'aimant permanent par rapport au premier interrupteur magnétique entre :
- une première position dans laquelle le champ magnétique généré par l'aimant permanent correspond, au niveau du premier interrupteur, à une configuration d'actionnement de ce premier interrupteur, et
- une seconde position dans laquelle le champ magnétique généré par l'aimant permanent ne correspond pas, au niveau du premier interrupteur, à une configuration d'actionnement de ce premier interrupteur.

5. Le générateur selon la revendication 4, dans lequel :
- le premier convertisseur (186) est apte à convertir l'énergie à récupérer en un excédent de charges électriques sur la première borne de raccordement dépassant le premier seuil prédéterminé lorsque l'aimant permanent est dans la première position, et en un excédent de charges électriques sur la seconde borne de raccordement dépassant un second seuil prédéterminé lorsque l'aimant permanent est dans la seconde position,
- le circuit (30) de collecte comporte un second interrupteur magnétique commandable (52 ; 126) raccordé à la seconde borne de raccordement, ce second interrupteur étant apte à commuter entre une position ouverte dans laquelle il empêche la décharge des charges électriques à travers la seconde borne de raccordement et une position fermée dans laquelle il autorise la décharge des charges électriques à travers la seconde borne de raccordement, le second interrupteur étant disposé par rapport à l'aimant permanent de manière à ce que :
• dans la première position, le champ magnétique généré par l'aimant permanent ne corresponde pas, au niveau du second interrupteur, à une configuration d'actionnement de ce second interrupteur, et
• dans la seconde position, le champ magnétique généré par l'aimant permanent corresponde, au niveau du second interrupteur, à une configuration d'actionnement de ce second interrupteur, les configurations d'actionnement des premier et second interrupteurs étant distinctes.

6. Le générateur selon l'une quelconque des revendications 4 à 5, dans lequel le premier convertisseur comporte :
- un premier transducteur électromécanique (72, 74 ; 196) apte à transformer une contrainte mécanique exercée sur ce transducteur électromécanique en une génération de l'excédent de charges électriques collecté par le circuit électrique de collecte, et
- un second transducteur (70 ; 200) fixé sans aucun degré de liberté au premier transducteur électromécanique, ce second transducteur étant apte à convertir une variation de l'énergie à récupérer en une contrainte mécanique exercée sur le transducteur électromécanique.

7. Le générateur selon la revendication 6, dans lequel, le second transducteur est un transducteur thermomécanique (200) apte à transformer une variation de température en une déformation mécanique de ce second transducteur.

8. Le générateur selon la revendication 7, dans lequel le transducteur thermomécanique (200) comporte un matériau à mémoire de forme.

9. Le générateur selon les revendications 4 et 6, dans lequel le même transducteur (200) forme à la fois le second transducteur du premier convertisseur (186) et le transducteur du dispositif de commande.

10. Le générateur selon la revendication 2 ou 5, dans lequel le premier interrupteur (48) est raccordé en série entre la première borne de raccordement et la borne de sortie pour isoler et, en alternance, raccorder électriquement la première borne de raccordement à la borne de sortie, et le second interrupteur (52) est raccordé en série entre la seconde borne de raccordement et la borne de sortie pour isoler et, en alternance, raccorder électriquement la seconde borne de raccordement à la borne de sortie.

11. Le générateur selon la revendication 2 ou 5, dans lequel :
- le premier convertisseur (20 ; 186), comme un condensateur, est apte, lorsque l'une quelconque des bornes de raccordement est électriquement isolée de tout circuit électrique, à conserver au moins 50 % de l'excédent de charges électriques amené précédemment sur cette borne pendant au moins 1 ms,
- le circuit de collecte comporte :
• une première et une seconde branches (116, 118) raccordées en parallèle l'une de l'autre entre les première et seconde bornes de raccordement, la première branche comportant le premier interrupteur (122) et la seconde branche comportant le second interrupteur (126),
• un interrupteur (134) commandable de libération raccordé en série entre l'une des bornes de raccordement et la borne de sortie, cet interrupteur étant commutable entre :
- un état non-passant dans lequel il isole électriquement cette borne de raccordement de la borne de sortie, et
- un état passant dans lequel il raccorde électriquement cette borne de raccordement à la borne de sortie,
- le dispositif (34) de commande est apte commander la commutation de l'interrupteur de libération vers son état passant uniquement quand l'excédent de charges électriques présent sur la borne de raccordement dépasse un troisième seuil prédéterminé strictement supérieur aux premier et second seuils prédéterminés.

12. Le générateur selon la revendication 11, dans lequel :
- le circuit de collecte comporte une bobine (132) raccordée en série avec le premier interrupteur de manière à être traversée par l'excédent de charges électriques produit par le premier convertisseur lorsque le premier interrupteur est dans sa position fermée, cette bobine générant un champ magnétique lorsqu'elle est traversée par l'excédent de charges électriques, et
- l'interrupteur (134) de libération est un interrupteur magnétique disposé par rapport à la bobine de manière à ce que le champ magnétique généré par cette bobine corresponde, au niveau de cet interrupteur, à une configuration d'actionnement de l'interrupteur de libération uniquement lorsque l'excédent de charges électriques dépasse le troisième seuil prédéterminé.

13. Le générateur selon la revendication 3 ou 6, dans lequel le transducteur électromécanique (72, 74 ; 196) du premier convertisseur comprend un matériau piézoélectrique.

## Patentansprüche

1. Elektrizitätsgenerator, der Folgendes umfasst:
- einen ersten Umsetzer (20), der einen ersten und einen zweiten Verbindungsanschluss (22, 24) aufweist, wobei dieser erste Umsetzer eine Änderung einer zurückzugewinnenden Energie in einen entsprechenden Überschuss elektrischer Ladungen an dem ersten Verbindungsanschluss in Bezug auf den zweiten Anschluss umsetzen kann,
- eine Schaltung (30; 114; 170; 174) zum Sammeln der überschüssigen elektrischen Ladungen an dem ersten Verbindungsanschluss, wobei diese Schaltung Folgendes umfasst:
• einen Ausgangsanschluss (40), über den die gesammelten Ladungen geliefert werden, und
• einen ersten steuerbaren mechanischen Unterbrecher (48; 122), der mit dem ersten Verbindungsanschluss verbunden ist, wobei dieser erste Unterbrecher zwischen einer offenen Position, in der er die Entladung der elektrischen Ladungen über den ersten Verbindungsanschluss verhindert, und einer geschlossenen Position, in der er die Entladung der elektrischen Ladungen über den ersten Verbindungsanschluss zulässt, umschalten kann, wobei die geschlossene Position in dem mechanischen Unterbrecher durch Abstützen eines elektrischen Kontakts direkt auf einem anderen elektrischen Kontakt, derart, dass eine elektrische Durchschaltung gebildet wird, erhalten wird und die offene Position durch die mechanische Trennung dieser beiden elektrischen Kontakte und die Einfügung eines elektrisch isolierenden Mediums zwischen diese beiden elektrischen Kontakte erhalten wird, und
- eine Vorrichtung (34) zum Steuern des ersten Unterbrechers, die das Umschalten dieses Unterbrechers in seine geschlossene Position steuern kann, wenn der Überschuss elektrischer Ladungen, der an dem ersten Verbindungsanschluss vorhanden ist, einen ersten vorgegebenen Schwellenwert überschreitet,
wobei:
- der erste Unterbrecher (48; 122) ein magnetischer Unterbrecher ist, wobei jeder magnetischer Unterbrecher wenigstens ein Plättchen (84, 86) aus magnetischem Material enthält, das die elektrischen Kontakte aus der offenen Position in die geschlossene Position verlagern kann, wenn das Magnetfeld auf Höhe des Unterbrechers in einer Betätigungskonfiguration ist, wobei der magnetische Unterbrecher seine elektrischen Kontakte außerhalb einer Betätigungskonfiguration des Magnetfeldes auf Höhe des magnetischen Unterbrechers nicht in der geschlossenen Position halten kann, und
- die Steuervorrichtung (34) eine Quelle für veränderliches Magnetfeld umfasst, wobei der erste Unterbrecher in Bezug auf diese Quelle in der Weise angeordnet ist, dass dieses veränderliche Magnetfeld, das sie auf Höhe dieses Unterbrechers erzeugt, eine Konfiguration zur Betätigung des ersten Unterbrechers ausschließlich zu dem Zeitpunkt erreicht, zu dem der Überschuss elektrischer Ladungen, der an dem ersten Verbindungsanschluss vorhanden ist, den ersten vorgegebenen Schwellenwert überschreitet,
**dadurch gekennzeichnet, dass** der erste Umsetzer (20) eine Änderung eines Magnetfeldes in einen entsprechenden Überschuss elektrischer Ladungen an dem ersten Verbindungsanschluss in Bezug auf den zweiten Anschluss umsetzen kann und der erste Umsetzer auf den Feldlinien der Quelle für veränderliches Magnetfeld angeordnet ist, um diese Änderungen des Magnetfeldes in einen entsprechenden Überschuss elektrischer Ladungen an dem ersten Verbindungsanschluss umzusetzen, derart, dass die zurückzugewinnende elektrische Energie die Quelle für das veränderliche Magnetfeld bildet.

2. Generator nach Anspruch 1, wobei:
- die Quelle (4) für veränderliches Magnetfeld ein veränderliches Magnetfeld erzeugen kann, dessen magnetisches Moment sich im Lauf der Zeit zwischen einer ersten und einer zweiten Position verändert,
- der erste Umsetzer (20) das veränderliche Magnetfeld in einen Überschuss elektrischer Ladungen an seinem ersten Verbindungsanschluss umsetzen kann, der den ersten vorgegebenen Schwellenwert für die erste Position des magnetischen Moments überschreitet, und in einen Überschuss elektrischer Ladungen an dem zweiten Verbindungsanschluss umsetzen kann, der einen zweiten vorgegebenen Schwellenwert für die zweite Position des magnetischen Moments überschreitet,
- die Sammelschaltung (30) einen zweiten steuerbaren magnetischen Unterbrecher (52; 126) enthält, der mit dem zweiten Verbindungsanschluss verbunden ist, wobei dieser zweite Unterbrecher zwischen seiner offenen Position, in der er die Entladung elektrischer Ladungen über den zweiten Verbindungsanschluss verhindert, und seiner geschlossenen Position, in der er die Entladung elektrischer Ladungen über den zweiten Verbindungsanschluss zulässt, umschalten kann, wobei der zweite Unterbrecher in Bezug auf diese Quelle in der Weise angeordnet ist, dass das veränderliche Magnetfeld, das sie auf Höhe dieses zweiten Unterbrechers erzeugt, eine Konfiguration zur Betätigung des zweiten Unterbrechers ausschließlich zu dem Zeitpunkt erreicht, zu dem der Überschuss elektrischer Ladungen, der an dem zweiten Verbindungsanschluss vorhanden ist, den zweiten vorgegebenen Schwellenwert überschreitet, wobei die Konfigurationen zur Betätigung des ersten und des zweiten Unterbrechers unterschiedlich sind.

3. Generator nach einem der Ansprüche 1 und 2, wobei der erste Umsetzer (20) Folgendes umfasst:
- einen elektromechanischen Wandler (72, 74), der eine mechanische Beanspruchung, die auf diesen elektromechanischen Wandler ausgeübt wird, direkt in einen Überschuss elektrischer Ladungen, die von der elektrischen Sammelschaltung gesammelt werden, transformieren kann, und
- einen magnetischen Wandler (70), der ohne jeden Freiheitsgrad an dem elektromechanischen Wandler befestigt ist, wobei dieser magnetische Wandler ein magnetostriktives Material enthält, das eine Änderung des veränderlichen Magnetfeldes in eine mechanische Beanspruchung, die auf den elektromechanischen Wandler ausgeübt wird, umsetzen kann.

4. Elektrizitätsgenerator, der Folgendes umfasst:
- einen ersten Umsetzer (186), der einen ersten und einen zweiten Verbindungsanschluss (188) aufweist, wobei dieser erste Umsetzer eine Änderung einer zurückzugewinnenden Energie in einen entsprechenden Überschuss elektrischer Ladungen an dem ersten Verbindungsanschluss in Bezug auf den zweiten Anschluss umsetzen kann,
- eine Schaltung (30; 114; 170; 174) zum Sammeln der überschüssigen elektrischen Ladungen an dem ersten Verbindungsanschluss, wobei diese Schaltung Folgendes umfasst:
• einen Ausgangsanschluss (40), über den die gesammelten Ladungen geliefert werden, und
• einen ersten steuerbaren mechanischen Unterbrecher (48; 122), der mit dem ersten Verbindungsanschluss verbunden ist, wobei dieser erste Unterbrecher zwischen einer offenen Position, in der er die Entladung elektrischer Ladungen über den ersten Verbindungsanschluss verhindert, und einer geschlossenen Position, in der er die Entladung elektrischer Ladungen über den ersten Verbindungsanschluss zulässt, umschalten kann, wobei die geschlossene Position in dem mechanischen Unterbrecher durch Abstützen eines elektrischen Kontakts direkt auf einem anderen elektrischen Kontakt, derart, dass eine elektrische Durchschaltung gebildet wird, erhalten wird und die offene Position durch die mechanische Trennung dieser beiden elektrischen Kontakte und die Einfügung eines elektrisch isolierenden Mediums zwischen diese beiden elektrischen Kontakte erhalten wird, und
- eine Vorrichtung (184) zum Steuern des ersten Unterbrechers, die das Umschalten dieses Unterbrechers in seine geschlossene Position steuern kann, wenn der Überschuss elektrischer Ladungen, der an dem ersten Verbindungsanschluss vorhanden ist, einen ersten vorgegebenen Schwellenwert überschreitet,
wobei:
- der erste Unterbrecher (48; 122) ein magnetischer Unterbrecher ist, wobei jeder magnetische Unterbrecher wenigstens ein Plättchen (84, 86) aus magnetischem Material enthält, das die elektrischen Kontakte aus der offenen Position in die geschlossene Position verlagern kann, wenn das Magnetfeld auf Höhe des Unterbrechers in einer Betätigungskonfiguration ist, wobei der magnetische Unterbrecher seine elektrischen Kontakte außerhalb einer Betätigungskonfiguration des Magnetfeldes auf Höhe des magnetischen Unterbrechers nicht in der geschlossenen Position halten kann, und
- die Steuervorrichtung (184) eine Quelle für veränderliches Magnetfeld enthält, wobei der erste Unterbrecher in Bezug auf diese Quelle in der Weise angeordnet ist, dass das veränderliche Magnetfeld, das sie auf Höhe dieses Unterbrechers erzeugt, eine Konfiguration zur Betätigung des ersten Unterbrechers ausschließlich zu dem Zeitpunkt erreicht, zu dem der Überschuss elektrischer Ladungen, der an dem ersten Verbindungsanschluss vorhanden ist, den ersten vorgegebenen Schwellenwert überschreitet,
**dadurch gekennzeichnet, dass** die Quelle für veränderliches Magnetfeld einen zweiten zusätzlichen Umsetzer enthält, der Folgendes umfasst:
• wenigstens einen Permanentmagneten (210),
• einen Wandler (200), der die Änderung der zurückzugewinnenden Energie in eine mechanische Verformung dieses Wandlers transformieren kann, und
• eine mechanische Verbindung zwischen dem Permanentmagneten und diesem Wandler, die die relative Position des Permanentmagneten in Bezug auf den ersten magnetischen Unterbrecher ändern kann zwischen:
- einer ersten Position, in der das durch den Permanentmagneten erzeugte Magnetfeld auf Höhe des ersten Unterbrechers einer Konfiguration zur Betätigung dieses ersten Unterbrechers entspricht, und
- einer zweiten Position, in der das durch den Permanentmagneten erzeugte Magnetfeld auf Höhe des ersten Unterbrechers keiner Konfiguration zur Betätigung dieses ersten Unterbrechers entspricht.

5. Generator nach Anspruch 4, wobei:
- der erste Umsetzer (186) die zurückzugewinnende Energie in einen Überschuss elektrischer Ladungen an dem ersten Verbindungsanschluss, der den ersten vorgegebenen Schwellenwert überschreitet, umsetzen kann, wenn der Permanentmagnet in der ersten Position ist, und in einen Überschuss elektrischer Ladungen an dem zweiten Verbindungsanschluss, der einen zweiten vorgegebenen Schwellenwert überschreitet, umsetzen kann, wenn der Permanentmagnet in der zweiten Position ist,
- die Sammelschaltung (30) einen zweiten steuerbaren magnetischen Unterbrecher (52; 126) umfasst, der mit dem zweiten Verbindungsanschluss verbunden ist, wobei dieser zweite Unterbrecher zwischen einer offenen Position, in der er die Entladung elektrischer Ladungen über den zweiten Verbindungsanschluss verhindert, und einer geschlossenen Position, in der er die Entladung elektrischer Ladungen über den zweiten Verbindungsanschluss zulässt, umschalten kann, wobei der zweite Unterbrecher in Bezug auf den Permanentmagneten in der Weise angeordnet ist, dass:
• in der ersten Position das durch den Permanentmagneten erzeugte Magnetfeld auf Höhe des zweiten Unterbrechers keiner Konfiguration zur Betätigung dieses zweiten Unterbrechers entspricht, und
• in der zweiten Position das durch den Permanentmagneten erzeugte Magnetfeld auf Höhe des zweiten Unterbrechers einer Konfiguration zur Betätigung dieses zweiten Unterbrechers entspricht, wobei die Konfigurationen zur Betätigung des ersten und des zweiten Unterbrechers unterschiedlich sind.

6. Generator nach einem der Ansprüche 4 bis 5, wobei der erste Umsetzer Folgendes umfasst:
- einen ersten elektromechanischen Wandler (72, 74; 196), der eine mechanische Beanspruchung, die auf diesen elektromechanischen Wandler ausgeübt wird, in eine Erzeugung des Überschusses elektrischer Ladungen, die von der elektrischen Sammelschaltung gesammelt werden, transformieren kann, und
- einen zweiten Wandler (70; 200), der ohne jeden Freiheitsgrad an dem ersten elektromechanischen Wandler befestigt ist, wobei dieser zweite Wandler eine Änderung der zurückzugewinnenden Energie in eine mechanische Beanspruchung umsetzen kann, die auf den elektromechanischen Wandler ausgeübt wird.

7. Generator nach Anspruch 6, wobei der zweite Wandler ein thermomechanischer Wandler (200) ist, der eine Temperaturänderung in eine mechanische Verformung dieses zweiten Wandlers transformieren kann.

8. Generator nach Anspruch 7, wobei der thermomechanische Wandler (200) ein Material mit Formerinnerungsvermögen enthält.

9. Generator nach den Ansprüchen 4 und 6, wobei derselbe Wandler (200) zugleich den zweiten Wandler des ersten Umsetzers (186) und den Wandler der Steuervorrichtung bildet.

10. Generator nach Anspruch 2 oder 5, wobei der erste Unterbrecher (48) zwischen dem ersten Verbindungsanschluss und dem Ausgangsanschluss in Reihe geschaltet ist, um den ersten Verbindungsanschluss und den Ausgangsanschluss abwechselnd elektrisch zu isolieren und zu verbinden, und der zweite Unterbrecher (52) zwischen dem zweiten Verbindungsanschluss und dem Ausganganschluss in Reihe geschaltet ist, um den zweiten Verbindungsanschluss und den Ausgangsanschluss abwechselnd elektrisch zu isolieren und zu verbinden.

11. Generator nach Anspruch 2 oder 5, wobei:
- der erste Umsetzer (20; 186) als ein Kondensator dann, wenn irgendeiner der Verbindungsanschlüsse von jeglicher elektrischer Schaltung elektrisch isoliert ist, wenigstens 50 % des Überschusses elektrischer Ladungen, die vorher diesem Anschluss zugeführt worden sind, während wenigstens 1 ms halten kann,
- wobei die Sammelschaltung Folgendes umfasst:
• einen ersten und einen zweiten Zweig (116, 118), die zwischen dem ersten und dem zweiten Verbindungsanschluss parallel geschaltet sind, wobei der erste Zweig den ersten Unterbrecher (122) enthält und der zweite Zweig den zweiten Unterbrecher (126) enthält,
• einen steuerbaren Freigabeunterbrecher (134), der zwischen einem der Verbindungsanschlüsse und dem Ausgangsanschluss in Reihe geschaltet ist, wobei dieser Unterbrecher umgeschaltet werden kann zwischen:
- einem Nichtdurchlasszustand, in dem er diesen Verbindungsanschluss von dem Ausgangsanschluss elektrisch isoliert, und
- einem Durchlasszustand, in dem er diesen Verbindungsanschluss mit dem Ausgangsanschluss elektrisch verbindet,
- wobei die Steuervorrichtung (34) das Umschalten des Freigabeunterbrechers in seinen Durchlasszustand ausschließlich dann steuern kann, wenn der Überschuss elektrischer Ladungen, der an dem Verbindungsanschluss vorhanden ist, einen dritten vorgegebenen Schwellenwert überschreitet, der streng größer als der erste und der zweite vorgegebene Schwellenwert ist.

12. Generator nach Anspruch 11, wobei:
- die Sammelschaltung eine Spule (132) enthält, die mit dem ersten Unterbrecher in Reihe geschaltet ist, derart, dass durch sie der Überschuss elektrischer Ladungen fließt, der von dem ersten Umsetzer erzeugt wird, wenn der erste Unterbrecher in seiner geschlossenen Position ist, wobei diese Spule ein Magnetfeld erzeugt, wenn sie von den überschüssigen elektrischen Ladungen durchflossen wird, und
- der Freigabeunterbrecher (134) ein magnetischer Unterbrecher ist, der in Bezug auf die Spule in der Weise angeordnet ist, dass das von dieser Spule erzeugte Magnetfeld auf Höhe dieses Unterbrechers einer Konfiguration zur Betätigung des Freigabeunterbrechers ausschließlich dann entspricht, wenn der Überschuss elektrischer Ladungen den dritten vorgegebenen Schwellenwert überschreitet.

13. Generator nach Anspruch 3 oder 6, wobei der elektromechanische Wandler (72, 74; 196) des ersten Umsetzers ein piezoelektrisches Material enthält.

## Claims

1. Electricity generator comprising:
- a first converter (20) equipped with first and second connection terminals (22, 24), this first converter being suitable for converting a variation of an energy to be harvested into a corresponding excess of electrical charges on the first connection terminal relative to the second terminal,
- a circuit (30; 114; 170; 174) for collecting the excess of electrical charges on the first connection terminal, this circuit being equipped:
• with an output terminal (40) via which the collected charges are delivered, and
• with a first controllable mechanical switch (48; 122) connected to the first connection terminal, this first switch being suitable for switching between an open position in which it prevents the discharging of the electrical charges through the first connection terminal and a closed position in which it allows the discharging of the electrical charges through the first connection terminal, the closed position in the mechanical switch being obtained by the bearing of an electrical contact directly on another electrical contact so as to establish an electrical continuity and the open position being obtained by the mechanical separation of these two electrical contacts and the interposition between these two electrical contacts of an electrically insulating medium, and
- a control device (34) for the first switch designed to control the switching of this switch to its closed position when the excess of electrical charges present on the first connection terminal exceeds a first predetermined threshold,
in which:
- the first switch (48; 122) is a magnetic switch, each magnetic switch comprising at least one blade (84, 86) made of magnetic material suitable for displacing the electrical contacts from the open position to the closed position when the magnetic field in the switch is in an actuation configuration, the magnetic switch being incapable of keeping its electrical contacts in the closed position outside of an actuation configuration of the magnetic field in the magnetic switch, and
- the control device (34) comprises a variable magnetic field source, the first switch being positioned relative to this source in such a way that the variable magnetic field that it generates in this switch reaches an actuation configuration of the first switch only at the time when the excess of electrical charges present on the first connection terminal exceeds the first predetermined threshold,
**characterized in that** the first converter (20) is suitable for converting a variation of a magnetic field into a corresponding excess of electrical charges on the first connection terminal relative to the second terminal and the first converter is placed in the field lines of the variable magnetic field source to convert these magnetic field variations into a corresponding excess of electrical charges on the first connection terminal such that the source of energy to be harvested is the variable magnetic field source.

2. Generator according to Claim 1, in which:
- the variable magnetic field source (4) is suitable for generating a variable magnetic field of which the magnetic moment varies over time between a first and a second positions,
- the first converter (20) is suitable for converting the variable magnetic field into an excess of electrical charges on the first connection terminal exceeding the first predetermined threshold for the first position of the magnetic moment, and into an excess of electrical charges on the second connection terminal exceeding a second predetermined threshold for the second position of the magnetic moment,
- the collection circuit (30) comprises a second controllable magnetic switch (52; 126) connected to the second connection terminal, this second switch being suitable for switching between its open position in which it prevents the discharging of the electrical charges through the second connection terminal and its closed position in which it allows the discharging of the electrical charges through the second connection terminal, the second switch being positioned relative to this source in such a way that the variable magnetic field that it generates in this second switch reaches an actuation configuration of the second switch only at the moment when the excess of electrical charges present on the second connection terminal exceeds the second predetermined threshold, the actuation configurations of the first and second switches being distinct.

3. Generator according to either one of Claims 1 and 2, in which the first converter (20) comprises:
- an electromechanical transducer (72, 74) suitable for directly transforming a mechanical stress exerted on this electromechanical transducer into an excess of electrical charges collected by the collection electrical circuit, and
- a magnetic transducer (70) fixed with no degree of freedom to the electromechanical transducer, this magnetic transducer comprising a magnetostrictive material suitable for converting a variation of the variable magnetic field into a mechanical stress exerted on the electromechanical transducer.

4. Electricity generator comprising:
- a first converter (186) equipped with first and second connection terminals (188), this first converter being suitable for converting a variation of an energy to be harvested into a corresponding excess of electrical charges on the first connection terminal relative to the second terminal,
- a circuit (30; 114; 170; 174) for collecting the excess of electrical charges on the first connection terminal, this circuit being equipped:
• with an output terminal (40) via which the collected charges are delivered, and
• with a first controllable mechanical switch (48; 122) connected to the first connection terminal, this first switch being suitable for switching between an open position in which it prevents the discharging of the electrical charges through the first connection terminal and a closed position in which it allows the discharging of the electrical charges through the first connection terminal, the closed position in the mechanical switch being obtained by the bearing of an electrical contact directly on another electrical contact so as to establish an electrical continuity and the open position being obtained by the mechanical separation of these two electrical contacts and the interposition between these two electrical contacts of an electrically insulating medium, and
- a control device (184) for the first switch designed to control the switching of this switch to its closed position when the excess of electrical charges present on the first connection terminal exceeds a first predetermined threshold,
in which:
- the first switch (48; 122) is a magnetic switch, each magnetic switch comprising at least one blade (84, 86) made of magnetic material suitable for displacing the electrical contacts from the open position to the closed position when the magnetic field in the switch is in an actuation configuration, the magnetic switch being incapable of keeping its electrical contacts in the closed position outside of an actuation configuration of the magnetic field in the magnetic switch, and
- the control device (184) comprises a variable magnetic field source, the first switch being positioned relative to this source in such a way that the variable magnetic field that it generates in this switch reaches an actuation configuration of the first switch only at the time when the excess of electrical charges present on the first connection terminal exceeds the first predetermined threshold, **characterized in that** the variable magnetic field source comprises a second additional converter comprising:
• at least one permanent magnet (210),
• a transducer (200) suitable for transforming the variation of the energy to be harvested into a mechanical deformation of this transducer, and
• a mechanical link between the permanent magnet and this transducer suitable for varying the relative position of the permanent magnet relative to the first magnetic switch between:
- a first position in which the magnetic field generated by the permanent magnet corresponds, in the first switch, to an actuation configuration of this first switch, and
- a second position in which the magnetic field generated by the permanent magnet does not correspond, in the first switch, to an actuation configuration of this first switch.

5. Generator according to Claim 4, in which:
- the first converter (186) is suitable for converting the energy to be harvested into an excess of electrical charges on the first connection terminal exceeding the first predetermined threshold when the permanent magnet is in the first position, and into an excess of electrical charges on the second connection terminal exceeding a second predetermined threshold when the permanent magnet is in the second position,
- the collection circuit (30) comprises a second controllable magnetic switch (52; 126) connected to the second connection terminal, this second switch being suitable for switching between an open position in which it prevents the discharging of the electrical charges through the second connection terminal and a closed position in which it allows the discharging of the electrical charges through the second connection terminal, the second switch being positioned relative to the permanent magnet in such a way that:
• in the first position, the magnetic field generated by the permanent magnet does not correspond, in the second switch, to an actuation configuration of this second switch, and
• in the second position, the magnetic field generated by the permanent magnet corresponds, in the second switch, to an actuation configuration of this second switch, the actuation configurations of the first and second switches being distinct.

6. Generator according to either one of Claims 4 and 5, in which the first converter comprises:
- a first electromechanical transducer (72, 74; 196) suitable for transforming a mechanical stress exerted on this electromechanical transducer into a generation of the excess of electrical charges collected by the collection electrical circuit, and
- a second transducer (70; 200) fixed with no degree of freedom to the first electromechanical transducer, this second transducer being suitable for converting a variation of the energy to be harvested into a mechanical stress exerted on the electromechanical transducer.

7. Generator according to Claim 6, in which the second transducer is a thermomechanical transducer (200) suitable for transforming a temperature variation into a mechanical deformation of this second transducer.

8. Generator according to Claim 7, in which the thermomechanical transducer (200) comprises a material with shape memory.

9. Generator according to Claims 4 and 6, in which the same transducer (200) forms both the second transducer of the first converter (186) and the transducer of the control device.

10. Generator according to Claim 2 or 5, in which the first switch (48) is connected in series between the first connection terminal and the output terminal to insulate and, alternately, electrically connect the first connection terminal to the output terminal, and the second switch (52) is connected in series between the second connection terminal and the output terminal to insulate and, alternately, electrically connect the second connection terminal to the output terminal.

11. Generator according to Claim 2 or 5, in which:
- the first converter (20; 186), such as a capacitor, is suitable, when any one of the connection terminals is electrically insulated from any electrical circuit, for retaining at least 50% of the excess of electrical charges brought previously to this terminal for at least 1 ms,
- the collection circuit comprises:
• a first and a second branches (116, 118) connected in parallel to one another between the first and second connection terminals, the first branch comprising the first switch (122) and the second branch comprising the second switch (126),
• a controllable releasing switch (134) connected in series between one of the connection terminals and the output terminal, this switch being able to be switched between:
- a non-conducting state in which it electrically insulates this connection terminal from the output terminal, and
- a conducting state in which it electrically connects this connection terminal to the output terminal,
- the control device (34) is suitable for controlling the switching of the releasing switch to its conducting state only when the excess of electrical charges present on the connection terminal exceeds a third predetermined threshold strictly greater than the first and second predetermined thresholds.

12. Generator according to Claim 11, in which:
- the collection circuit comprises a coil (132) connected in series with the first switch so as to be passed through by the excess of electrical charges produced by the first converter when the first switch is in its closed position, this coil generating a magnetic field when it is passed through by the excess of electrical charges, and
- the releasing switch (134) is a magnetic switch positioned relative to the coil in such a way that the magnetic field generated by this coil corresponds, in this switch, to an actuation configuration of the releasing switch only when the excess of electrical charges exceeds the third predetermined threshold.

13. Generator according to Claim 3 or 6, in which the electromechanical transducer (72, 74; 196) of the first converter comprises a piezoelectric material.
